# EUROPÄISCHE PATENTSCHRIFT

(11) **EP 1 590 510 B1**
(45) Veröffentlichungstag und Bekanntmachung des Hinweises auf die Patenterteilung: **28.03.2007**
(21) Anmeldenummer: 04703345.1
(22) Anmeldetag: 20.01.2004
(51) Int. Cl.: C30B 31/10

(54) **VORRICHTUNG ZUR HERSTELLUNG ELEKTRISCH LEITFÄHIGER DURCHGÄNGE IN EINEM HALBLEITERWAFER MITTELS THERMOMIGRATION**
DEVICE FOR PRODUCING ELECTROCONDUCTIVE PASSAGES IN A SEMICONDUCTOR WAFER BY MEANS OF THERMOMIGRATION
DISPOSITIF POUR REALISER DES PASSAGES ELECTRIQUEMENT CONDUCTEURS DANS UNE TRANCHE DE SEMI-CONDUCTEUR, AU MOYEN D'UNE MIGRATION THERMIQUE

(30) Priorität: 20.01.2003 DE 10302653
(43) Veröffentlichungstag der Anmeldung: 02.11.2005
(73) Patentinhaber: HTM Reetz GmbH, 12555 Berlin (DE); Silicon Sensor GmbH, 12459 Berlin (DE)
(72) Erfinder: KUDELLA, Frank, 12589 Berlin (DE); REETZ, Roland, 12623 Berlin (DE); EN LEN, Marko, 12459 Berlin (DE); RASEL, Mario, 10437 Berlin (DE); SCHINDEL, Karsten, 12683 Berlin (DE); KRIEGEL, Bernd, 12559 Berlin (DE)
(74) Vertreter: Ninnemann, Detlef
(86) Internationale Anmeldenummer: PCT/DE2004/000069
(87) Internationale Veröffentlichungsnummer: WO 2004/066347

(56) Entgegenhaltungen:
- WO-A-83/03710
- US-A- 3 897 277
- US-A- 3 910 801
- US-B1- 6 300 256

## Beschreibung

Die Erfindung bezieht sich auf eine Vorrichtung zur Herstellung elektrisch leitfähiger Durchgänge in einem Halbleiterwafer mittels Thermomigration gemäß dem Oberbegriff des Anspruchs 1.

Der Thermomigrationsprozeß, auch Temperatur-Gradienten-Zonenschmelz-Prozeß (TGZM-Prozeß) genannt, insbesondere der von Aluminium in Silizium, ist ein spezielles Dotierverfahren, mit dem es möglich ist, in n-leitendem Silizium p-leitende, aluminiumdotierte Kanäle, Linien oder Rahmen zu erzeugen, welche die gegenüberliegenden Oberflächen eines Halbleiterkörpers, insbesondere eines Halbleiterwafers, miteinander verbinden. Ein solcher Prozeß ist beispielsweise in den US-Patenten No. 3.897277 von Blumenfield oder den US-Patenten No. 3.901.736, No. 3.910.801, No. 3.898.106, No. 3.902.925, No. 3.899.361 von Anthony and Cline oder in US 6.300.256 B1 von Kriegel und in WO 83/03710 von Brown beschrieben.

Bei dieser Art von Prozeß migriert bei ausreichender Temperatur eine zunächst in fester Form lokal auf den Halbleiterwafer aufgebrachte Metallschicht als flüssige Zone entlang eines Temperaturgradienten durch den Halbleiterwafer hindurch und hinterlässt eine auf dem Niveau der Löslichkeitskonzentration des Metalls bei der Prozeßtemperatur dotierte Spur im Halbleitermaterial. Dieses Patent beschreibt eine besonders geeignete Vorrichtung zur Durchführung eines solchen Thermomigrationsprozesses.

Für einen Thermomigrationsprozesses wird beispielsweise ein Siliziumwafer in eine Vorrichtung gegeben, die aus einer Wärmequelle und einer Wärmesenke besteht, zwischen denen der zu bearbeitende Siliziumwafer eingebracht wird. Zwischen der Wärmequelle und der Wärmesenke fließt ein Wärmestrom, welcher auch den Siliziumwafer senkrecht durchströmt. Wegen der endlichen Wärmeleitung des Siliziums entsteht zwischen beiden Waferoberflächen eine Temperaturdifferenz und damit ein Temperaturgradient.

Befinden sich die Wärmequelle und Wärmesenke im Vakuum, so erfolgt der Energiestrom allein über den Wärmestrahlungsmechanismus. Wird zwischen Wärmequelle und Wärmesenke ein wärmeleitendes Medium eingebracht, wie zum Beispiel Helium, kann der Wärmetransport effektiver durch zusätzliche Wärmeleitung ablaufen. Im Prozeß wird der Siliziumwafer auf 900°C bis 1300°C erhitzt. Wird auf die kühlere Oberfläche des Siliziumwafers ein geeigneter metallischer Dotierungsstoff gegeben, beispielsweise Aluminium zur p-Dotierung, so migriert der metallische Dotierungsstoff mit dem gelösten umgebenden Halbleitermaterial als Tröpfchen einer Ausdehnung von wenigen 10 µm infolge des durch Heizen der einen und Kühlen der anderen Waferseite erzeugten Temperatur-gradienten in dem Siliziumwafer zu der gegenüberliegenden, wärmeren Oberfläche des Siliziumwafers und erzeugt auf dem zurückgelegten Weg eine dotierte Spur.

Thermomigrierte Strukturen werden in Form von Säulen, Kanälen, Linien- oder Rahmenstrukturen für SMD-Bauelemente (Surface Mounted Devices), bei denen die Kontaktstellen beider Elektroden auf einer Oberfläche des Bauelements angeordnet werden können, so dass das Bauelement mit seiner Rückseite an eine mit geeigneten Kontaktflächen versehene Leiterplatte angeschlossen werden, ohne dass zusätzliche Drähte oder andere Verbindungselemente benötigt werden, in Fotodioden-Arrays, zur elektrischen Isolation benachbarter Schaltungen in einem Chip (npn-Back-to-Back-Diode-Isolation), für Micro Electro Mechanical Systems (MEMS) und dergleichen, verwendet.

Die Anwendung eines Thermomigrationsverfahrens erfordert zum Aufbau eines intensiven Wärmestromes und damit eines Temperaturgradienten von typisch 20 bis 100 K/cm im Silizium eine lateral homogene Erwärmung der einen Waferseite des präparierten Halbleiterwafers auf ca. 900 °C bis 1300 °C und gleichzeitig eine effektive, ebenfalls lateral homogene Kühlung der anderen Waferseite.

Aus der WO 83/03710 ist ein Verfahren zur Durchführung eines Thermomigrationsprozesses an Halbleitern bekannt, bei dem der entsprechend vorbereitete Halbleiter mit der einen Oberfläche auf eine im Wesentlichen ebene Oberfläche einer Wärmequelle gelegt wird. Der Halbleiter wird aufgeheizt, wobei eine Temperaturdifferenz zwischen den beiden Oberflächen des Halbleiters aufgebaut wird. Auf den Halbleiter aufgebrachte Tropfen von entgegengesetzt leitendem Material wandern dabei durch den Halbleiter und bilden leitende Verbindungen zwischen den beiden Oberflächen. Anschließend wird das Heizelement abgekühlt und der Halbleiter entnommen. Durch den direkten Kontakt zwischen Halbleiter und Wärmequelle wird ein hoher Temperaturgradient im Halbleiter erzeugt und somit eine Beschleunigung des Verfahrens erreicht.

Die zur Durchführung des Verfahrens verwendete Vorrichtung enthält einen scheibenförmigen Graphitsuszeptor zur Aufnahme mehrerer zu migrierender Siliziumwafer in eingefrästen Vertiefungen, der in einer Rezipientenkammer mit wassergekühltem Mantel angeordnet ist. Der Suszeptor lagert auf einem Quarzstempel, der mit einer durch den Rezipientenboden geführten Drehvorrichtung verbunden ist. Die Aufheizung des Suszeptors erfolgt induktiv, wozu sich unter dem Suszeptor ein Flächeninduktor befindet, der von einem RF-Leistungsgenerator angesteuert wird. Die feststehende Wärmesenke in Form eines wasserdurchströmten Kühltopfes ist dicht über dem Suszeptor angeordnet und wird zu Beginn des Prozesszyklus evakuiert und im anschließenden Migrationsprozess mit Helium bei atmosphärischem Druck durchströmt.

Da Graphit in sehr reinen Qualitäten zur Verfügung steht und einen extrem niedrigen Dampfdruck aufweist, ist in dieser Anordnung das Kontaminationsproblem für eine Reihe von Anwendungen ausreichend gelöst. Gleichzeitig weist in dieser Anordnung die Wärmequelle eine gute laterale Homogenität auf und kann damit beliebig dicht an den Siliziumwafer herangeführt werden. Anstelle der Wärmestrahlung erfolgt die Wärmeabgabe an den Siliziumwafer mittels Wärmeleitung durch direkten Kontakt zwischen dem Graphitsuszeptor und dem darauf liegenden Siliziumwafer. Für die Wärmeabgabe an die Wärmesenke wird neben der Wärmestrahlung auch die Wärmeleitung im Gas als Transportmechanismus genutzt, was durch die Verwendung von Helium als Prozessgas unterstützt wird. Gleichzeitig kann in gewissen Grenzen der Abstand zwischen Wärmesenke und Siliziumwafer verringert werden, was die Möglichkeiten, den Temperaturgradienten im Prozess zu beeinflussen, vergrößert.

Die Nachteile der bekannten Vorrichtung bestehen darin, dass der Abstand zwischen dem Kühltopf und der Oberfläche des Siliziumwafers aus technischen Gründen nicht beliebig gering sein kann, da sich beide gegeneinander bewegen und an unterschiedlichen Anlagenkomponenten befestigt sind. Des weiteren kann der Gasdruck zur Steuerung des Wärmetransportes zwischen dem Siliziumwafer und dem Kühltopf nicht variiert werden.

Aufgabe der vorliegenden Erfindung ist es, eine Vorrichtung zur Thermomigration der eingangs genannten Gattung anzugeben, die eine homogene, effektive und weitgehend unabhängig voneinander einstellbare Aufheizung und Kühlung von Halbleiterwafern gewährleistet, die gleichzeitige Bearbeitung mehrerer Halbleiterwafer bei minimaler Prozesszeit ermöglicht, die Reinheitsanforderungen der Halbleitertechnologie erfüllt, sich insbesondere für die Bearbeitung von Hochohmsilizium eignet, einen geringen Energieverbrauch, einen minimalen und über den Prozessgasdruck sowie den Abstand steuerbaren Wärmewiderstand zwischen Wärmesenke und Waferoberfläche aufweist, sowie einen automatischen Prozessablauf und eine hohe technische Verfügbarkeit mit reproduzierbarer Prozessführung ermöglicht.

Diese Aufgabe wird erfindungsgemäß durch die Merkmale des Anspruchs 1 gelöst.

Die erfindungsgemäße Vorrichtung gewährleistet zur Herstellung elektrisch leitfähiger Durchgänge in einem Halbleiterwafer mittels Thermomigration eine homogene, effektive und weitgehend unabhängig voneinander einstellbare Aufheizung und Kühlung des Halbleiterwafers, ermöglicht die gleichzeitige Bearbeitung mehrerer Halbleiterwafer bei minimaler Prozesszeit, erfüllt die Reinheitsanforderungen der Halbleitertechnologie, eignet sich insbesondere auch für die Bearbeitung von Hochohmsilizium, weist einen geringen Energieverbrauch sowie einen minimalen und über den Prozessgasdruck sowie den Abstand steuerbaren Wärmewiderstand zwischen Wärmesenke und Waferoberfläche auf und ermöglicht einen automatischen Prozessablauf und eine hohe technische Verfügbarkeit mit reproduzierbarer Prozessführung.

Diese Vorteile werden insbesondere dadurch erzielt, dass der Abstand zwischen der Unterseite der Wärmesenke und der Oberseite des Halbleiterwafers auf ein Maß gesenkt werden kann, das nur noch von der Qualität der Oberflächen abhängt und bei den heute üblichen Fertigungsgenauigkeiten im Bereich weniger Zehntel Millimeter liegt. Damit lassen sich auch bei Suszeptoren mit großem Durchmesser von 400 bis 700 mm, die Voraussetzung für die gleichzeitige Bearbeitung mehrerer Halbleiterwafer bei minimaler Prozesszeit sind, sehr kleine Abstände reproduzierbar und ohne Keiligkeit zwischen der Wärmsenke und der Suszeptoroberfläche einstellen, die auch während der Rotation des Suszeptors unverändert bleiben.

Weiterhin wird durch die Ankopplung des Suszeptors an die Wärmesenke und dessen induktive Erwärmung die Voraussetzung für einen kontaminationsarmen Prozessraum geschaffen. Durch die gemeinsame Rotation des Suszeptors und der Wärmesenke mit etwa 30 bis 50 Umdrehungen pro Minute werden zirkulare Temperaturdifferenzen ausgeschlossen und damit eine gleichmäßige Durchwärmung des bzw. der Halbleiterwafer erzielt.

Vorzugsweise ist der Suszeptor in Richtung der Wärmesenke federnd vorgespannt und zwischen der Wärmesenke und dem Suszeptor oder einer den Suszeptor aufnehmenden Unterlage sind Abstandshalter angeordnet.

Dadurch wirkt auf den Suszeptor ständig eine Kraft ein, die danach strebt, den Spalt zwischen der Wärmesenke und der Waferoberfläche zu verringern, wobei der exakte Abstand zwischen der Unterseite der Wärmesenke und der Waferoberfläche mit den Abstandshaltern eingestellt werden kann.

In einer bevorzugten Ausführungsform besteht die Wärmesenke aus einem rotationssymmetrischen Kühltopf mit einem der Waferoberfläche zugewandten kreisscheiben- oder kreisringförmigen Kühltopfboden, wobei der Kühltopf vakuumdicht und drehbar durch eine Öffnung des Rezipienten geführt ist, und in seinem aus dem Rezipienten herausragenden Teil mindestens einen zylindrischen Abschnitt, durch den das Kühlmedium zu- und abgeleitet wird, und eine vom Kühlmedium getrennte Leitung zur Zufuhr des gut wärmeleitenden Prozessgases aufweist.

Durch die Unterteilung des Rezipienten in zwei gasdicht voneinander getrennte Gasräume, von denen der eine Gasraum aus einem den Suszeptor aufnehmenden Prozessraum und der andere Gasraum aus einem den Induktor aufnehmenden Induktorraum besteht, wird der Prozessraum mit dem Suszeptor und dem Halbleiterwafer vor möglichen Schwermetallkontamination geschützt, die insbesondere in Form von Kupfer und Gold von dem zur induktiven Erwärmung des Suszeptors dienenden Induktor abgegeben werden können, die Wahl einer elektrisch besonders spannungs- bzw. überschlagsfesten Gasatmosphäre am Induktor sowie eines unterschiedlichen Gasdruckes im Prozessraum und im Induktorraum und auch eines unterhalb des atmosphärischen Druckes liegenden Druckes ermöglicht und eine effektive laminare Schutzgasspülung zwischen Suszeptor und Wärmesenke bei geringem Gasverbrauch durch Helium als Prozessgas im Grobvakuumbereich gewährleistet.

Dementsprechend wird der Prozessraum vorzugsweise mit dem gut wärmeleitenden Prozessgas, insbesondere Helium, das die Waferoberfläche laminar umströmt, und der Induktorraum mit einem Gas hoher Spannungs- oder Durchschlagsfestigkeit, beispielsweise mit trockenem Stickstoff, SF₆ oder einer Mischung aus beiden Gasen, gefüllt bzw. durchströmt und es werden wahlweise unterschiedliche und in Abhängigkeit voneinander regelbare Gasdrücke im Prozess- und Induktorraum eingestellt.

Weiterhin kann die Thermomigrationsvorrichtung evakuiert oder erhitzt werden, ohne dass sich die eingestellten Abstände zwischen den Oberflächen der Wärmesenke und des Suszeptors verändern.

Der Induktorraum wird durch ein mit dem Rezipientenboden verbundenes elektrisch isolierendes Gefäß, insbesondere ein zumindest in Teilbereichen seiner Oberfläche transparentes Gefäß, vorzugsweise eine Quarzglocke, gasdicht vom Prozessraum abgeteilt.

In einer bevorzugten Ausführungsform besteht der Rezipient aus einem den Suszeptor und einem die Wärmesenke (auch Kühltopf genannt) aufnehmenden Oberteil und einem den Induktor und/oder das den Induktor enthaltende, zumindest teilweise transparente Gefäß umgebenden Unterteil, das mit der Bodenfläche des Rezipienten verbunden ist.

Zum erleichterten Beschicken der Thermomigrationsvorrichtung mit Halbleiterwafern sowie zum Entnehmen der bearbeiteten Halbleiterwafer ist das mit der Wärmesenke/Kühltopf und dem Suszeptor verbundene Oberteil vom Unterteil lösbar, anhebbar und wegschwenkbar.

Da an die Reinheitsanforderungen bei der Thermomigration je nach Anwendungsgebiet unterschiedliche Anforderungen gestellt werden, kann bei weniger kritischer Kontamination oder geringeren Reinheitsanforderungen auf die Trennung von Prozeß- und Induktorraum und damit auf die gasdichte Quarzglocke und auf das technisch aufwendige Differenzdruckregelsystem zwischen den beiden getennten Gasräumen verzichtet werden. Der Wegfall der gasdichten Quarzglocke mit einer Dicke von ca. 10 bis 15 mm ermöglicht zusätzlich eine Veringerung des Abstandes zwischen Suszeptor und Induktor, was zur Erhöhung des Wirkungsgrades der induktiven Heizvorrichtung führt, da für dieselbe induzierte Leistung im Suszeptor eine geringere Blindleistung im Induktorschwingkreis verbraucht wird.

Zusätzlich wird wegen des Wegfalls der unvermeidlichen thermischen Ankopplung der Oberseite der Quarzglocke an die geometrisch nahe Suszeptorunterseite und der dadurch bedingten verringerten thermischen Trägheit, die sich bei zwei getrennten Gasräumen insbesondere in der Aufheizphase des Suszeptors vornehmlich über die Wärmeleitung durch die Helium-Gasschicht zwischen dem Suszeptor und der Quarzglocke störend bemerkbar macht, die laterale Temperaturhomogenität des Suszeptors verbessert.

Wegen der lösbaren Verbindung zwischen Suszeptor und Wärmesenke bleibt aber weiterhin der wesentliche Vorteil einer definierten Einstellmöglichkeit kleiner Abstände zwischen dem Suszeptor und der Wärmesenke, auch bei großen Durchmessern, insbesondere zur Realisierung besonders hoher Temperaturgradienten vom mehreren 100 K/cm in Silizium, erhalten.

In einer weiteren Ausführungsform der Erfindung ist die Temperatur des Außenrandes des Suszeptors niedriger als dessen den Halbleiterwafer aufnehmende Innenfläche und der Außenrand des Suszeptors ist lösbar mit einem im Randbereich des kreisscheiben- oder kreisringförmigen Kühltopfbodens angeordneten Aufnahmeabschnitt des Kühltopfs verbunden.

Vorzugsweise ist zwischen dem Außenrand des Suszeptors und der den Halbleiterwafer aufnehmenden Innenfläche des Suszeptors ein den Wärmefluss von der Innenfläche zum Außenrand verringernder Abschnitt vorzugsweise aus mehreren schmalen Stegen, Einfräsungen oder dergleichen vorgesehen. Dabei schränken die schmalen Stege und Einfräsungen den Wärmefluss zwischen dem zentralen, heißen Bereich der Innenfläche des Suszeptors, in dem die Halbleiterwafer aufliegen, und dem kälteren Außenrand ein, so dass die Verbindungsmittel zwischen dem Suszeptor und der Wärmesenke keinen erhöhten Wärmebeanspruchungen ausgesetzt sind.

Zudem ermöglicht die thermische Trennung des Außenrandes von der Innenfläche ein für den Thermomigrationsprozess vorteilhaftes schnelles Rampenfahren sowie eine größere Homogenität bei der Wärmeverteilung, da ansonsten ein erheblicher Anteil der im Suszeptor generierten Wärme über den Außenrand abgeführt werden würde. Die schmalen langen Stege verhindern gleichzeitig den Aufbau mechanischer Spannungen als Folge der Temperaturdifferenz zwischen dem Auflagebereich der Halbleiterwafer auf der Innenfläche und dem Außenrand.

Damit in den vom inneren Teil des Suszeptors thermisch entkoppelten Außenrand des Suszeptors möglichst wenig Leistung induziert wird weist der Außenrand des Suszeptors vorzugsweise einen größeren vertikalen Abstand zum Induktor als seine den Halbleiterwafer aufnehmende Innenfläche auf.

Die Abwinklung des Außenrandes dient der Vergrößerung des Abstandes von der stark erhitzten Innenfläche zum Rand des Suszeptors, so dass die Wärmebelastung der Befestigungselemente zur Verbindung des Suszeptors mit der Wärmesenke weiter verringert wird und die Befestigungselemente in einem Bereich des Suszeptors angeordnet werden können, der außerhalb des vom Induktor abgegebenen Feldes liegt, so dass der Abstand zwischen dem Suszeptor und dem Induktor minimiert werden kann.

Alternativ kann anstelle eines napf- oder tellerförmigen Suszeptors auch ein scheibenförmiger Suszeptor verwendet werden, der über den äußeren kreisscheibenförmigen Rand mit der Wärmesenke verbunden wird. Auch bei dieser ebenen Suszeptorgeometrie, sind äußerer und innenerer Bereich vorzugsweise nur durch lange schmale Stege miteinander verbunden Diese geometrische Form bedingt zwar einen größeren Abstand zum Induktor, ermöglicht aber die Herstellung eines sehr einfach geformten Suszeptors. Diese Ausgestaltung des Suszeptors eignet sich insbesondere für eine vereinfachte Ausführungsform der Thermomigrationsvorrichtung, bei der auf eine Trennung der Gasräume verzichtet wird und wegen des Wegfalls der Quarzglocke ein geringer Abstand zum Induktor ohne Probleme bei der Verbindung des Suszeptors mit der Wärmesenke eingestellt werden kann.

Zur exakten Einstellung des Abstandes zwischen der Oberfläche des Halbleiterwafers bzw. des Suszeptors und der Wärmesenke bzw. des Kühltopfbodens können zwischen der Bodenfläche des Kühltopfes und dem Außenrand und/oder der Innenfläche des Suszeptors vorzugsweise als Quarzglaszylinder ausgebildete Abstandshalter aus einem hochtemperaturfesten elektrisch isolierenden Material geringer Wärmeleitung und hoher Temperaturschockbeständigkeit angeordnet werden, die als zylindrische Stäbe, Röhren oder flache Ronden auf die Oberfläche des Suszeptors aufgelegt werden. Alternativ können zwischen der Oberfläche der Unterlage des Suszeptors und der Bodenfläche des Kühltopfes in Freimachungen im Außenrand des Suszeptors positionierte Abstandshalter vorgesehen werden.

Um die Gefahr von kontaminierenden Ausdampfungen seitens der Kühltopf-Oberfläche zu vermindern, wird diese durch eine passivierende Beschichtung beispielsweise mit Titannitrid, DLC (diamantartigem Kohlenstoff) oder Siliziumkarbid passiviert, so dass keine Gefahr von Verunreinigungen des auf dem Suszeptor angeordneten Halbleiterwafers besteht.

Aus den gleichen Gründen kann auch die Suszeptoroberfläche mit einer dünnen Passivierungsschicht, vorzugsweise aus SiC, Al₂O₃, TiN oder DLC beschichtet werden.
Passivierungsschichten auf der Suszeptoroberfläche vermindern auch das Anbacken der Halbleiterwafer an der Suszeptoroberfläche am Ende des Thermomigrationsprozesses als reaktive AlSi-Schmeize. Als ein weiteres Trennmedium zwischen Suszeptoroberfläche und Halbleiteroberfläche können sehr dünne Abstandshalter vorgesehen werden, beispielsweise Fasern aus Quarzglas einer Länge von 5 bis 15 mm und einer Dicke von 10 bis etwa 50 µm. Neben der sicheren Trennung zwischen Suszeptor- und Waferoberfläche bewirken sie einen über die gesamte Oberfläche des Halbleiterwafers homogenen Wärmeübergang zur Suszeptoroberfläche, vermittelt über die trennende dünne Gasschicht aus Helium.

Zur Optimierung der Kühlung des Kühltopfbodens und zur Minimierung des Wärmewiderstandes des Kühltopfbodens weist der Kühltopf Blenden, Zwischenwände und/oder Versteifungsrippen auf und das Kühlmedium wird in den aus dem Rezipienten ragenden Teil des Kühltopfes eingeleitet, um die Rotationsachse des Kühltopfes zur Mitte der vom Suszeptor abgewandten Oberfläche des kreisscheiben- oder kreisringförmigen Kühltopfbodens, entlang dieser Oberfläche zu deren äußerem Rand und zurück zu dem aus dem Rezipienten ragenden Teil des Kühltopfes geführt und dort abgeleitet, wobei an der vom Rezipienten abgewandten Oberfläche des kreisscheiben- oder kreisringförmigen Kühltopfbodens mehrere Kanäle angeordnet oder ausgebildet sind, deren Zahl sich mit zunehmendem Radius erhöht, während sich der Querschnitt jedes einzelnen Kanals dabei vermindert, und die Dicke des Kühltopfbodens von innen nach außen abnimmt.

Vorzugsweise ist der vertikale Abstand zwischen dem inneren Bereich des Kühltopfbodens, unter dem sich kein Halbleiterwafer befindet, und der Ebene der Waferoberfläche größer als der Abstand zwischen den Abschnitten des Kühltopfbodens, die dem Halbleiterwafer gegenüberliegen und der Waferoberfläche, wobei der Abstand im Zentimeterbereich liegt.

Der Induktor besteht aus einem spiral- oder mäanderförmig gebogenen Rohr, vorzugsweise aus Kupfer mit dick vergoldeter Oberfläche als Flächeninduktor, wobei die Induktorleitungen durch eine elektrisch isolierte Durchführung durch den Rezipientenboden geführt sind.

Die einzelnen Windungen des spiral- oder mäanderförmigen Induktors sind bezüglich ihres Abstandes zum Suszeptor einstellbar, so dass durch sorgfältige Justage dieser Abstände auf dem Suszeptor ein radial sehr homogenes Temperaturprofil eingestellt werden kann.

Die den Suszeptor mit dem Kühltopf verbindenden Verbindungselemente weisen Federn auf, die eine den Suszeptor in Richtung des Kühltopfbodens ziehende Kraft erzeugen, wobei die Verbindungselemente einerseits am Außenrand und/oder der Unterlage des Suszeptors und am Aufnahmeabschnitt des Kühltopfes angreifen.

Die durch die Federn erzeugte Kraft wird vorzugsweise durch einfach geformte Körper oder in der Länge verstellbare Baugruppen aufgenommen, die sich zwischen dem Kühltopf und dem Suszeptor oder der Unterlage des Suszeptors befinden, und mit ihrer Länge den Abstand zwischen der Oberfläche des auf dem Suszeptor liegenden Halbleiterwafers und den gegenüberliegenden Abschnitten der Bodenfläche des Kühltopfes bestimmen.

Der offene Innenbereich des Suszeptors wird durch eine Scheibe aus isolierendem Material, insbesondere aus Quarz, abgedeckt, so dass das Prozessgas nur durch den Spalt zwischen dem Halbleiterwafer und dem Kühltopf nach außen strömen kann. Über dem offenen Zentrum des Suszeptors wird der Boden des Kühltopfes zurück-, d.h. vom Induktor weggezogen.

In einer bevorzugten Ausführungsform der Erfindung wird der Wärmestrom zwischen dem Suszeptor und der Wärmesenke durch das Produkt der Temperaturdifferenz von dem in den Kühltopf einströmenden und ausströmenden Kühlmedium, multipliziert mit seinem Volumenstrom und seiner spezifischen Wärmekapazität gemessen. Aus der Bestimmung des Wärmestromes kann dann die jeweilige Einstellung des Abstandes zwischen Kühltopf und Suszeptor bzw. der Abstände zwischen Kühltopf, Suszeptor und/oder Induktor sowie der Druck im Rezipienten ermittelt und eingestellt werden.

Weitere Vorteile und Merkmale der Erfindung ergeben sich aus der nachstehenden Beschreibung von in der Zeichnung dargestellten Ausführungsbeispielen der Erfindung, die unter Bezugnahme auf die Zeichnungsfiguren näher erläutert werden sollen. Es zeigen:
- Fig. 1: eine Prinzipskizze einer Vorrichtung mit an einer Wärmesenke befestigtem Suszeptor und zwei getrennten Gasräumen;
- Fig. 2: eine Prinzipskizze der Druck- und Gasregelung in der Vorrichtung gemäß Fig. 1;
- Fig. 3: eine Prinzipskizze der Druck-und Gasregelung in einer Vorrichtung mit an der Wärmesenke befestigtem Suszeptor und einem Gasraum;
- Fig. 4: einen detaillierten Längsschnitt durch eine erste Ausführungsform einer erfindungsgemäßen Thermomigrationsvorrichtung;
- Fig. 5: eine vergrößerte Darstellung des Details IV gemäß Figur 4;
- Fig. 6: einen Teilschnitt durch eine zweite Ausführungsform einer erfindungsgemäßen Thermomigrationsvorrichtung;
- Fig. 7 und 8: vergrößerte Darstellungen der Details VII und VIII gemäß Fig. 6 und
- Fig. 9 bis 11: verschiedene Darstellungen eines in den Thermomigrationsvorichtungen gemäß den Fig. 4 und 6 verwendeten Graphitsuszeptors.

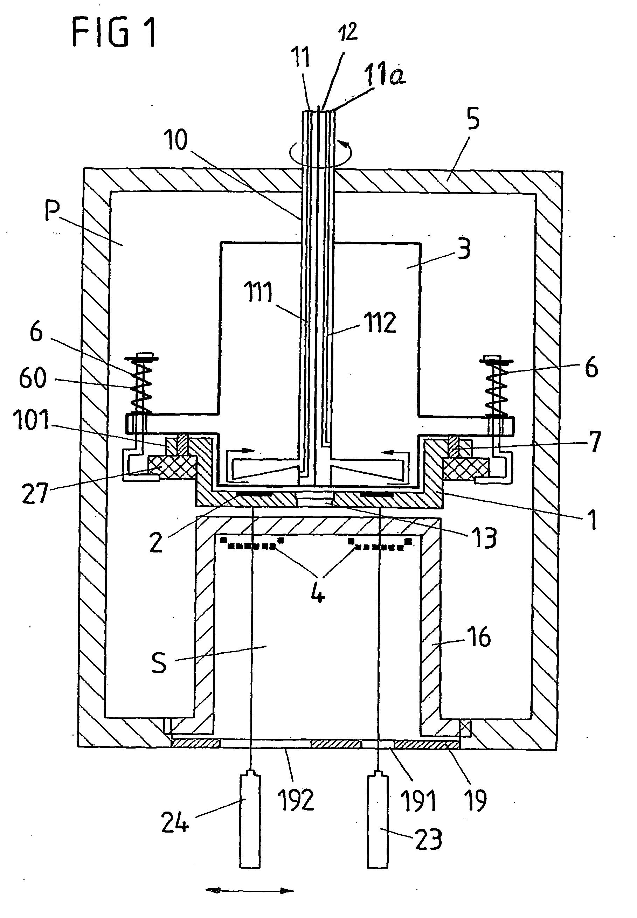

Fig. 1 zeigt eine Prinzipskizze einer erfindungsgemäß ausgebildeten Thermomigrationsvorrichtung, bei der sich in einem Rezipienten 5 mit wassergekühltem Mantel ein als Wärmesenke dienender Kühltopf 3 befindet, an den ein Graphitsuszeptor 1 mit mehreren ausgefrästen Wafermulden mit darin angeordneten Halbleiterwafern 2 angehängt ist. Der Außenrand 101 des Suszeptors 1 liegt auf einem Quarzträgerring 27 auf, der über federgestraffte Verbindungselemente 6 zum Boden des Kühltopfes 3 gezogen wird. Über mehrere, verteilt angeordnete zylindrische Abstandshalter 7, vorzugsweise aus Quarzglas, wird der je nach gewünschtem Wärmestrom zwischen dem Halbleiterwafer 2 und dem Kühltopf 3 bzw. der Wärmesenke der Abstand zwischen der Oberseite des Suszeptors 1 und damit der Oberseite der auf dem Suszeptor 1 aufliegenden Halbleiterwafer 2 einerseits und dem Boden des Kühltopfs 3 andererseits sehr genau und homogen über einen großen Durchmesser von beispielsweise 450 mm im Bereich von 0,5 bis 5,0 mm eingestellt.

Der Suszeptor 1 wird mit einem im Abstand vorzugsweise von weniger als 20 mm unterhalb des Suszeptors 1 angeordneten Induktor 4 induktiv durch Wirbelströme aufgeheizt, der von einem regelbaren MF-Generator mit einer Arbeitsfrequenz von vorzugsweise 15 bis 50 kHz und beispielsweise einer Maximalleistung von ca. 100 kW für einen Suszeptor mit einem Durchmesser von ca. 450 mm gespeist wird. Typische Prozesstemperaturen der in Fig. 1 prinzipiell dargestellten Thermomigrationsvorrichtung liegen im Bereich zwischen 1000 °C und 1270 °C.

Zur Temperaturmessung werden zwei Pyrometer 23, 24 eingesetzt, mit denen die Temperatur der Unterseite des Suszeptors 1 durch Messfenster 191, 192 im Boden 19 einer gasdichten, den Induktor 4 aufnehmenden Quarzglocke 16 gemessen wird. Der Messstrahlengang der Pyrometer 23, 24 verläuft jeweils in einer Lücke zwischen zwei Induktorwindungen hindurch.

Die Pyrometer 23, 24 sind mit Feinfocusoptiken ausgestattet, so dass trotz eines Abstandes der Induktorwindungen von nur 6 wenigen Millimetern Messwertverfälschungen durch Signalabschattungen ausgeschlossen werden können. Während das Pyrometer 23 stationär positioniert ist und das Messsignal für die Temperaturregelung liefert, ist das Pyrometer 24 seitlich verfahrbar und erfasst die radiale Temperaturverteilung des Suszeptors 1.

Die einzelnen Windungen des Induktors 4 sind in ihrem Abstand zum Suszeptor 1 einstellbar, so dass durch Justage der Abstände der Windungen des Induktors 4 ein radial sehr homogenes Temperaturprofil am Suszeptor 1 eingestellt werden kann. Zirkulare Temperaturdifferenzen werden durch Rotation mit etwa 30 bis 50 Umdrehungen pro Minute der im Prozess verbundenen Baugruppe bestehend, aus dem Suszeptor 1 und dem Kühltopf 3, ausgeschlossen.

Zur Abfuhr des Wärmestromes aus der Wärmesenke wird der Kühltopf 3 intensiv mit Wasser durchströmt. Über Messung der Zu- und Abflusstemperatur sowie des Volumenflusses wird die abgeführte Energie bestimmt und der Wärmestrom in W/cm² ermittelt.

In der mit einem Antriebsmotor verbundenen Welle 10 des Kühltopfes 3 befinden sich isoliert ein Gaskanal 12 für ein in den Rezipienten 5 geleitetes Prozessgas, vorzugsweise Helium, und Zu- und Abflußkanäle 111, 112 eines Kühlflüssigkeitskanal 11, für den Zu- und Abfluss des Kühlmediums Wasser zum Kühltopf 3.

Um den Induktor 4 als Kontaminationsquelle für den Hochtemperaturprozess auszuschließen, ist er vom Prozessraum P im Rezipienten 5 isoliert in einem Induktorraum S angeordnet. Die Trennung in Prozessraum P und Induktorraum S erfolgt durch die den Induktor 4 enthaltende Quarzglocke 16.

Eine weitere Maßnahme zur Erhöhung der Halbleiterreinheit ist die Absenkung des Helium-Arbeitsdruckes während des Prozesses von atmosphärischem Druck auf 30 bis 150 mb. Konvektionsströmungen im Prozessraum P werden unterbunden und der Wärmewiderstand zwischen der Unterseite des Kühltopfes 3 und der Oberfläche des Halbleiterwafers 2 kann bei ausreichend niedrigen Drücken ohne Veränderung des Abstandes im Prozess variiert werden, wobei sich die Einstellung unterschiedlicher Drücke in der Aufheiz- und Migrationsphase als vorteilhaft erwiesen haben. Weiterhin werden bei gleichem Massestrom des Prozessgases, Restgasspuren durch den ständigen Pumpprozess und infolge der höheren Geschwindigkeit des laminaren Gasstromes besser entfernt, als durch einen Spülgasstrom bei etwa 1000 mb.

Durch den verringerten Arbeitsdruck und eine Spannung von mehr als 1,0 kV am Induktor 4 kann es leicht zu Gasentladungen oder Überschlägen im Induktorraum S kommen. Helium zeigt diesbezüglich ein besonders ungünstiges Verhalten, so dass im Induktorraum S kein Helium, sondern trockener Stickstoff, SF₆ oder eine Mischung beider Gase eingeleitet wird. Dabei kann der Gasdruck wegen der hohem Durchschlagsfestigkeit des Stickstoffs und/oder SF₆ mit Rücksicht auf die Belastbarkeit der Quarzglocke 16 verringert werden.

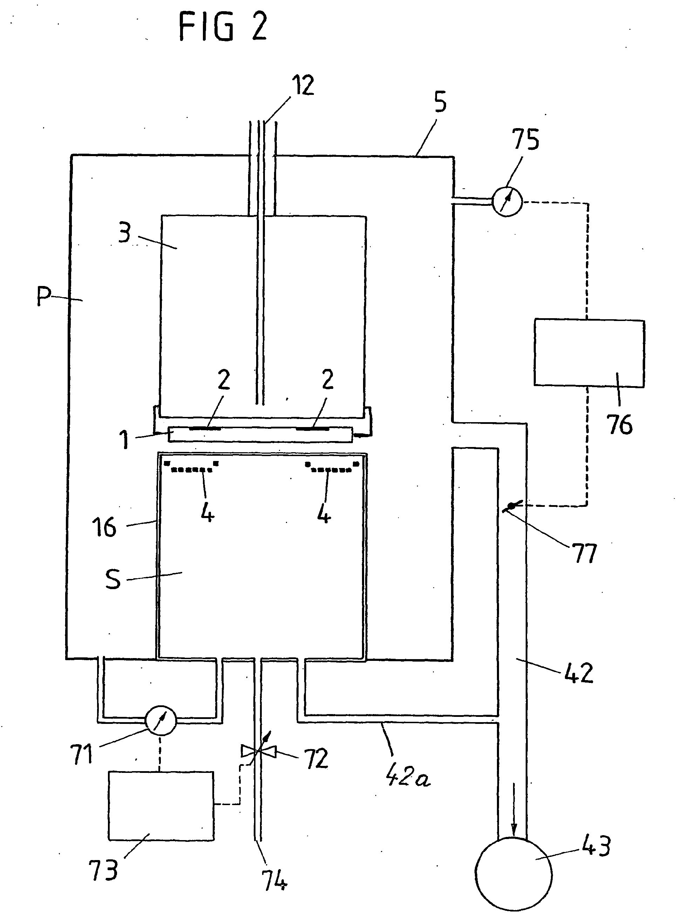

Zu diesem Zweck ist die Thermomigrationsvorrichtung gemäß Fig. 2 mit einer Gassteuerung ausgestattet. In den Prozessraum P wird über einen Einlass in den Gaskanal 12 Heliumgas eingeleitet. Der Gasdruck im Prozessraum P wird über einen Gasdrucksensor 75 gemessen. Ein Druckregler 76 mit elektronisch gesteuertem Drosselventil 77 in einer Abpumpleitung 42, die zu einer Vakuumpumpe 43 führt, stellt den Gasdruck im Prozessraum P unabhängig vom eingeleiteten Gasstrom ein.

In jedem Betriebszustand der Thermomigrationsvorrichtung wird der Differenzdruck zwischen dem Induktorraum S und dem Prozessraum P überwacht und der Druck in dem Induktorraum S auf einen, um den vorgegebenen Differenzdruck höheren Druck, geregelt. Zu diesem Zweck ist zwischen dem Prozessraum P und dem Induktorraum S ein Differenzdrucksensor 71 angeordnet und mit beiden Gasräumen P und S verbunden. Zusammen mit einem Gasregelventil 72 am Stickstoffeinlass 74 zum Induktorraum S wird der vorgegebene Differenzdruck von beispielsweise 70 mb zwischen beiden Gasräumen P und S mit Hilfe eines Differenzdruckreglers 73 eingestellt. Das Gas aus dem Induktorraum S wird über die Abpumpleitung 42a zur Vakuumpumpe 43 geführt.

Die in den Fig. 1 und 2 im Prinzip dargestellte und vorstehend beschriebene Thermomigrationsvorrichtung erfordert eine zuverlässige Differenzdruckregelung zwischen den beiden Gasräumen P und S sowie infolge der gasdichten Quarzglocke 16 mit einer Dicke von ca. 10 bis 15 mm einen etwas größeren Abstand zwischen dem Suszeptor 1 und dem Induktor 4, was zur Verringerung des Wirkungsgrades der Thermomigrationsvorrichtung führt, da für dieselbe induzierte Leistung im Suszeptor 1 eine größere Spannung am Induktor 4 benötigt wird und somit mehr Blindleistung im Induktorschwingkreis erzeugt wird.

Weiterhin besteht eine - wenn auch geringfügige - thermische Ankopplung der Oberseite der Quarzglocke 16 an den Suszeptor 1. Infolgedessen wird die thermischen Trägheit vergrößert, was sich insbesondere in der Aufheiz- und Abkühlphase des Suszeptors 1 vornehmlich über die Wärmeleitung durch die Helium-Gasschicht zwischen dem Suszeptor 1 und der Quarzglocke 16 störend bemerkbar macht.

An die Reinheitsanforderungen bei der Thermomigration werden aber je nach Anwendungsgebiet unterschiedliche Anforderungen gestellt, d.h. es werden unterschiedliche maximale Kontaminationslevel zugelassen. Beispielsweise sind bei Anwendungen in der Mikrosystemtechnik wie Micro Electro Mechanical Systems (MEMS) prozessbedingte Schwermetallkontaminationen zumeist weitaus weniger störend als für Bauelemente, welche hohe Minoritätsladungsträgerlebensdauern benötigen, wie beispielsweise Strahlungsdetektoren und Photodioden.

Ist die Kontamination nicht so kritisch, kann auf die Trennung von Prozess- und Induktorraum und damit verbunden auf das technisch aufwendige Differenzdruckregelsystem verzichtet werden, wobei jedoch wegen der lösbaren Verbindung zwischen Suszeptor 1 und Wärmesenke 3 der wesentliche Vorteil einer definierten Einstellmöglichkeit kleiner Abstände zwischen Suszeptor 1 und Wärmesenke 3, insbesondere zur Realisierung besonders hoher Temperaturgradienten vom mehreren 100 K/cm in Silizium erhalten bleibt.

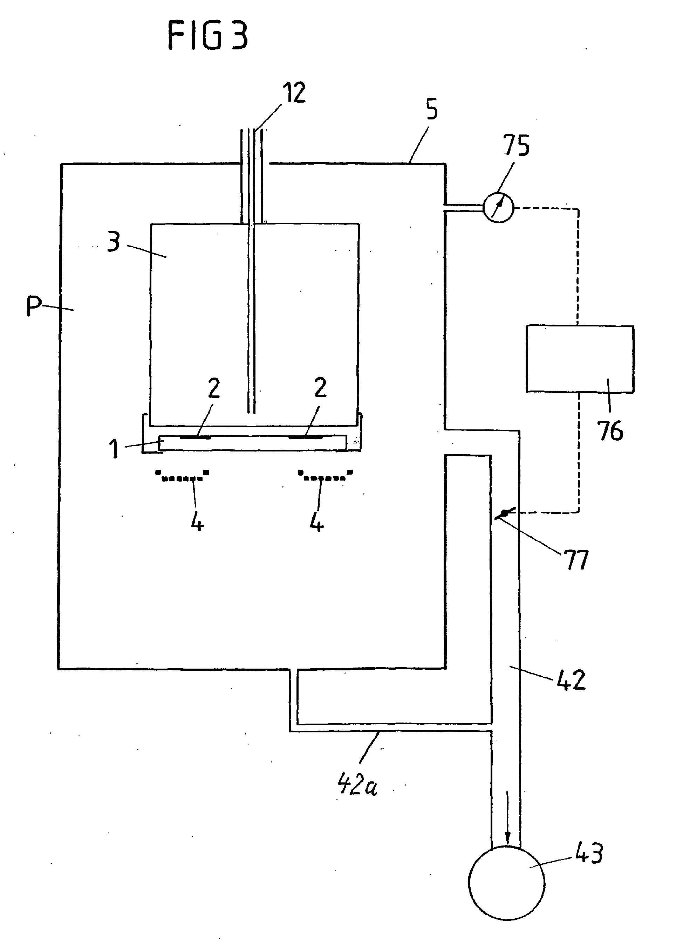

In Fig. 3 ist eine Prinzipskizze der Druck- und Gasregelung in einer Vorrichtung mit an der Wärmesenke 3 befestigtem Suszeptor 1 und einem vom Rezipienten 5 eingefassten einheitlichen Gasraum P dargestellt.

In dieser Anordnung entfällt im Unterschied zur Thermomigrationsvorrichtung gemäß den Fig. 1 und 2 die Quarzglocke 16 zur Abtrennung des den Induktor 4 enthaltenden Induktorraums S vom Prozessraum P, so dass sich der Induktor 4 zusammen mit dem Suszeptor 1 im Prozessraum P befindet. Weiterhin entfällt in dieser vereinfachten Variante der erfindungsgemäßen Thermomigrationsvorrichtung das Differenzdruckregelsystem mit dem zwischen dem Prozessraum P und dem Induktorraum S angeordneten Differenzdrucksensor 71, das Gasregelventil 72 am Stickstoffeinlass 74 zum Induktorraum S, mit dem der vorgegebene Differenzdruck zwischen den beiden Gasräumen P und S eingestellt wird, und der Differenzdruckregler 73 gemäß Fig. 2.

Dagegen verbleibt die Gassteuerung, mit der in den Prozessraum P über den Einlass in den Gaskanal 12 Heliumgas eingeleitet, der Gasdruck im Prozessraum P über den Gasdrucksensor 75 gemessen und mittels des Druckreglers 76 mit elektronisch gesteuertem Drosselventil 77 in der Abpumpleitung 42 der Gasdruck im Prozessraum P unabhängig vom eingeleiteten Gasstrom eingestellt wird.

Wie nachstehend näher ausgeführt wird, kann der Suszeptor 1 in dieser vereinfachten Ausführungsform als einfache zylindrische Scheibe gestaltet werden, da wegen des Wegfalls der Quarzglocke 16 ein geringer Abstand zum Induktor 4 ohne Probleme bei der Verbindung des Suszeptors 1 mit der Wärmesenke 3 eingestellt werden kann.

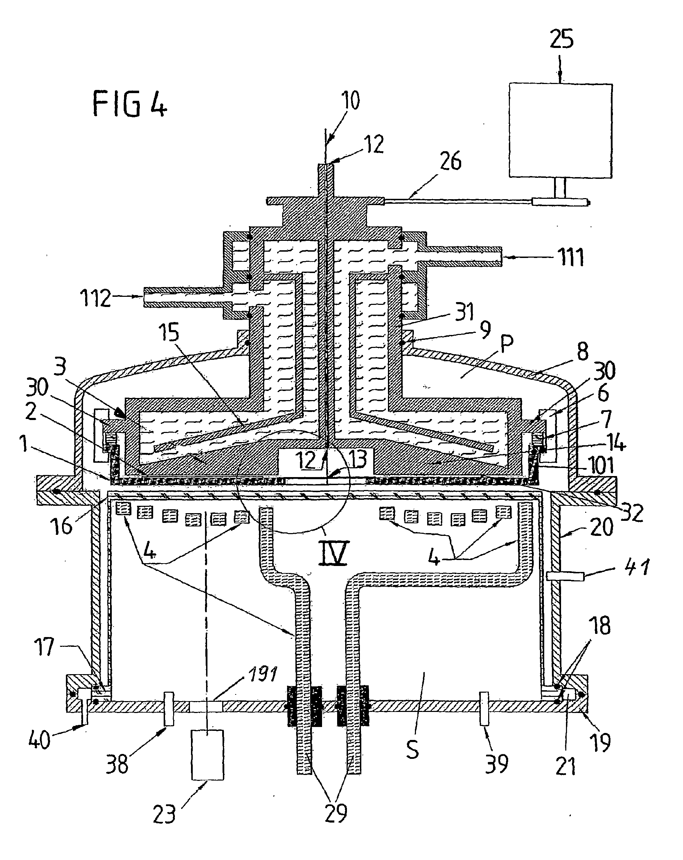

Weiterhin kann auf einen den Suszeptor 1 tragenden Quarzring 27 gemäß Fig. 1 verzichtet werden, so dass der Suszeptor 1 direkt durch Formelemente von seiner Unterseite her federnd in Richtung der Wärmesenke 3 gedrückt wird. Der Abstand zwischen dem Suszeptor 1 und der Wärmesenke 3 wird - wie nachstehend an Hand der Fig. 4 näher erläutert wird - durch auf der Oberfläche des Suszeptor 1 positionierte Distanzstücke aus einem hochtemperaturfesten elektrisch isolierenden Material geringer Wärmeleitung und hoher Temperaturschockbeständigkeit, wie beispielsweise Quarzglas, in Form aufgelegter zylindrischer Stäbe, Röhren oder flache Ronden, eingestellt.

Fig. 4 zeigt einen Längsschnitt durch eine Themomigrationsvorrichtung mit zwei voneinander getrennten Gasräumen, einem Prozessraum P und einem Induktorraum S.

Im Prozessraum P befindet sich ein Suszeptor 1, auf dessen Oberfläche Halbleiterwafer 2 aufliegen, die mittels eines Thermomigrationsprozesses bearbeitet werden sollen. Der vorzugsweise aus Graphit bestehende Suszeptor 1 ist formschlüssig, kraftschlüssig oder als Kombination von beidem mit seinem äußeren Rand 101 insbesondere über Verbindungselemente 6 in Form von Klammern, Pratzen oder dergleichen lösbar mit Aufnahmeelementen 30 einer Wärmesenke in Form eines kühlwasserdurchströmten Kühltopfes 3 aus gut wärmeleitendem Material, beispielsweise Aluminium oder einer Aluminiumlegierung, verbunden. In Fig. 4 nicht dargestellt, erzeugen mit den Verbindungselementen 6 verbundene Federn eine ständig wirkende Kraft, die danach strebt, den Spalt zwischen der Wärmesenke 3 und dem Suszeptor 1 zu verringern.

Der Kühltopf 3 ist drehbar und vakuumdicht durch ein glockenförmiges Oberteil 8 des Rezipienten 5 geführt und rotiert während der Thermomigration. Zur Beschickung der Thermomigrationsvorrichtung kann das Oberteil 8 angehoben und in eine Be- bzw. Entladeposition für die zu bearbeitenden Halbleiterwafer geschwenkt werden. Vorzugsweise handelt es sich beim Kühltopf 3 um einen annähernd rotationssymmetrischen Körper, dessen Achse mit der Rotationsachse bzw. Welle 10 zusammenfällt und dessen Zylindermantel 31 durch eine Drehdurchführung 9 des Oberteils 8 des Rezipienten 5 geführt ist.

Der Abstand zwischen der Oberfläche des Halbleiterwafers 2 bzw. des Suszeptors 1 und der Wärmesenke 3 bzw. des Kühltopfbodens 14 wird mit Abstandshaltern 7, die insbesondere aus geschliffenen Quarzkörpern bestehen, oder mit Distanzstücken 32 aus einem hochtemperaturfesten elektrisch isolierenden Material geringer Wärmeleitung und hoher Temperaturschockbeständigkeit, wie beispielsweise Quarzglas, die als zylindrische Stäbe, Röhren oder flache Ronden auf die Oberfläche des Suszeptors 1 aufgelegt werden, eingestellt und gesichert.

Der bzw. die Halbleiterwafer 2 liegt/liegen auf der Oberfläche des Suszeptors 1, wobei ihre Position mit geeigneten Elementen, bei denen es sich z.B. um Vertiefungen im Suszeptor 1 oder Aufnahmeringe handeln kann, fixiert wird.

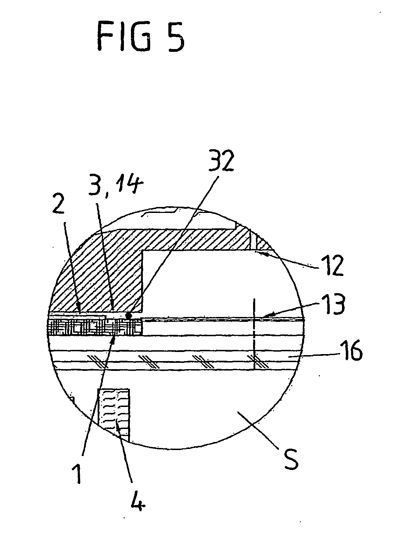

Der Prozessraum P wird vom Rezipienten 5 umschlossen, der sich aus dem glockenförmigen Oberteil 8, einem zylinderförmigen Unterteil 20 und einem Rezipientenboden 19 zusammensetzt. Das Oberteil 8 weist die vakuumdichte Drehdurchführung 9 für den Kühltopf 3 auf, der die Welle 10 enthält, die mittels eines Antriebsmotors 25 über ein Transmissionselement 26 in Form einer Kette, eines Zahnrades, einer Zahnriemenscheibe, eines Riemens oder dergleichen drehbar ist. Infolge der Verbindung des Kühltopfs 3 mit dem Suszeptor 1 wird dieser ebenfalls mitgedreht. Die durch die Welle 10 gebildete Rotationsachse des Kühltopfes 3 weist einen Einlass in einen Gaskanal 12 für das Prozessgas, vorzugsweise Helium, sowie Ein- und Auslässe 111, 112 für das Kühlmedium, vorzugsweise Wasser, auf. Der Prozessgaskanal 12 führt zu einer Ausnehmung des Kühltopfes 3, der eine in die Oerfläche des Suszeptors 1 eingelassene Scheibe 13 aus Quarzglas gegenübersteht (Fig. 5).

Im Prozessraum P wird eine Heliumatmosphäre mit Drücken zwischen 20 und 300 mbar aufrechterhalten, die mit einer Downstream-Regelung in weiten Grenzen unabhängig von der einströmenden Helium-Menge eingestellt werden kann.

Innerhalb des Kühltopfes 3 strömt das Kühlwasser über den Kühltopfboden 14 von innen nach außen und wird dabei durch Zwischenwände 15 geführt, deren Abstand zum Kühltopfboden 14 sich nach außen hin zunehmend verringert. Weiterhin ist der Kühltopfboden 14 stark verrippt und weist demzufolge eine große, von Kühlwasser umströmte Oberfläche auf. Zusätzlich bewirkt die starke Rippung des Innenbereichs des Kühltopfes ein hohes Flächenträgheitsmoment, so dass der Kühltopf 3 in Bezug auf den erhöhten Druck der Kühlflüssigkeit eine ausreichende mechanische Festigkeit besitzt.

Die Dicke des Kühltopfbodens 14 verringert sich von innen nach außen, so dass der Wärmewiderstand des Kühltopfbodens 14 nach außen abnimmt.

Um die Gefahr von Ausdampfungen seitens der Kühltopf-Oberfläche zu vermindern, wird diese durch Beschichtung mit beispielsweise Titannitrid, DLC (diamantartigem Kohlenstoff) oder Siliziumkarbid passiviert, so dass keine Gefahr von Verunreinigungen der auf dem Suszeptor 1 angeordneten Halbleiterwafer besteht.

Unterhalb des Suszeptors 1 ist in dem vom Prozessraum P abgetrennten Induktorraum S ein Induktor 4 aus einem spiralförmig gewickeltem Kupferrohr einer angeordnet, der über Induktoranschlußleitungen 29 mit einem regelbaren MF-Generator verbunden ist. Die Trennung zwischen Prozessraum P und Induktorraum S erfolgt mittels einer gasdichten Quarzglocke 16. Die einzelnen Windungen des spiralförmig gewickelten Induktors 4 sind bezüglich ihres Abstandes zum Suszeptor 1 einstellbar, so dass durch sorgfältige Justage dieser Abstände auf dem Suszeptor 1 ein radial sehr homogenes Temperaturprofil eingestellt werden kann.

Die Quarzglocke 16 endet in einem-Flanschring 17, der mit zwei Elastomerringen 18 elastisch zwischen dem Rezipientenboden 19 und dem zylinderförmigen Unterteil 20 des Rezipienten 5 eingespannt ist. Zwischen dem Rezipientenboden 19 und dem zylinderförmigen Unterteil 20 des Rezipienten 5 sowie dem Mantel des Flanschringes der Quarzglocke 16 wird ein Ringspalt 21 gelassen und soweit evakuiert, dass der Druck dort unter dem Niveau der Drücke im Induktorraum S und im Prozessraum P bleibt und ein Gasaustausch zwischen den Räumen P und S selbst bei geringem Andruck der Elastomerringe 18 nicht stattfinden kann.

In den Kammerboden 19 ist ein Gaseinlass 38 für das Gas im Induktorraum S sowie ein Pumpstutzen 39 zum Gasauslass eingelassen.

Im Induktorraum S liegt eine Atmosphäre aus trockenem Stickstoff mit etwas höheren Drücken als im Prozessraum P vor, die mit bekannten technischen Mitteln so ausgeregelt werden, dass der Differenzdruck zum Prozessraum P unter 100 mbar bleibt.

Der offene Innenbereich des Suszeptors 1 wird durch eine Scheibe 13 aus isolierendem Material, insbesondere aus Quarz, abgedeckt, so dass das Prozessgas nur durch den Spalt zwischen dem Halbleiterwafer 2 und dem Kühltopf 3 nach außen strömen kann. Über dem offenen Zentrum des Suszeptors 1 wird der Boden des Kühltopfes 3 zurück-, d.h. vom Induktor 4 weggezogen.

Die Messung der Suszeptortemperatur erfolgt mit einem oder mehreren Pyrometern 23, die durch Fenster 191 im Rezipientenboden 19 unter Nutzung von Lücken zwischen den Windungen des Induktors 4 durch die Quarzglocke 16 auf die Suszeptorunterseite gerichtet sind.

Fig. 5 zeigt in vergrößerter Darstellung die dichte Anordnung und Verbindung des Suszeptors 1 mit darauf befindlichem Halbleiterwafer 2 sowohl in Bezug auf den als Wärmesenke dienenden Kühltopf 3 als auch in Bezug auf den im Induktorraum S angeordneten Induktor 4, der durch die Deckfläche der gasdichten Quarzglocke 16 getrennt ist. Die im Suszeptor 2 vorgesehene zentrale Bohrung ist durch die elektrisch isolierende Scheibe 13 abgedeckt. Weiterhin kann der Darstellung gemäß Fig. 5 der Auslass des Gaskanals 12 für die Zufuhr des Prozessgases Helium und die Anordnung der Distanzstücke 32 entnommen werden, die den Abstand zwischen dem Suszeptor 1 und dem Kühltopfboden 14 und damit der Wärmesenke einstellen und den Abstand sicherstellen.

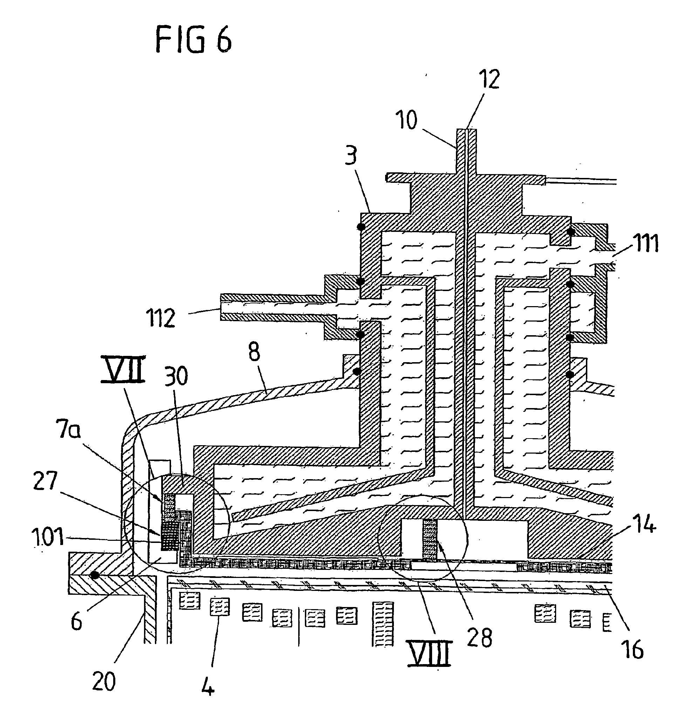

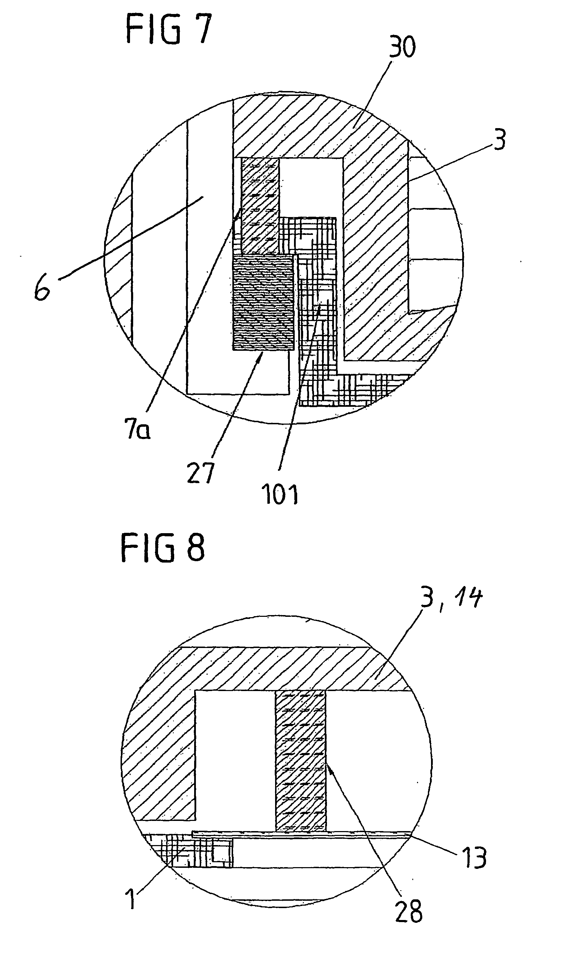

In Fig. 6 sowie in vergrößerter Darstellung der Details VII und VIII gemäß Fig. 6 in den Fig. 7 und 8 ist eine Variante der erfindungsgemäßen Thermomigrationsvorrichtung dargestellt, bei der der Suszeptor 1 auf einer Unterlage 27, beispielsweise einem Ring aus Quarzglas, aufliegt, an der die Verbindungselemente 6 angreifen. Der Suszeptor 1 ist im Verbindungsbereich mit Bohrungen ausgestattet, in die Abstandshalter 7a eingesetzt werden, so dass sich die Abstandshalter 7a nicht mehr wie die Abstandshalter 32 auf dem Suszeptor 1, sondern auf der Unterlage 27 abstützen.

Weiterhin ist der Suszeptor 1 im Innenbereich zusätzlich mit Abstandshaltern 28 gegen die Wärmesenke 3, d.h. den Kühltopfboden 14 abgestützt, damit er nicht aus dem magnetischen Feld des Induktors 4 heraus gegen die Wärmesenke 3 gedrückt werden kann.

Fig. 7 zeigt in vergrößerter Darstellung des Details VII gemäß Fig. 6 die Verbindung des Suszeptors 1 mit dem Aufnahmeelement 30 des Kühltopfes 3. In dieser Ausführungsform liegt der abgewinkelte Außenrand 101 des Suszeptors 1 auf der Unterlage 27 in Form eines Ringes aus Quarzglas auf. An der Unterlage 27 und an den Aufnahmeelementen 30 greifen die Verbindungselemente 6an. In die Bohrungen des Suszeptors 1 im Verbindungsbereich sind die Abstandshalter 7a eingesetzt und stützen sich an der Unterlage 27 und am Aufnahmeelement 30 der Wärmesenke bzw. am Kühltopf 3 ab.

Fig. 8 zeigt in vergrößerter Darstellung das Detail VIII gemäß Fig. 6 und verdeutlicht, wie der Suszeptor 1 in seinem durch eine elektrisch isolierende Scheibe 13 abgedeckten Ausnehmungsbereich zusätzlich mit Abstandshaltern 28 gegenüber der Wärmesenke 3 abgestützt ist.

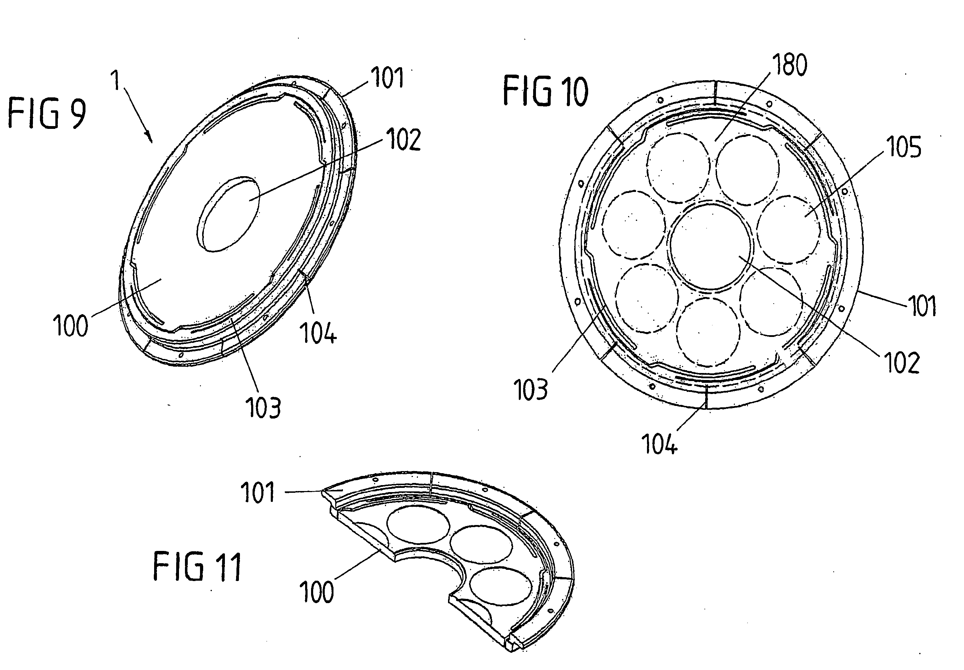

In den Fig. 9 bis 11 ist eine Ausführungsform eines Suszeptors 1 dargestellt, wobei Fig. 9 eine perspektivische Unterseitenansicht des Suszeptors 1, Fig. 10 eine Draufsicht auf die Oberseite des Suszeptors 1 und Fig. 11 eine perspektivische Ansicht der geschnitten dargestellten Oberseite des Suszeptors 1 zeigt.

Der Suszeptor 1 weist eine kreisringförmige Innenfläche 100 auf, die in der Mitte eine zentrale Bohrung 102 enthält. Von der kreisringförmigen Innenfläche 100 geht ein abgewinkelter Außenrand 101 ab, die dem Suszeptor 1 eine Napf- oder Tellerform verleiht. Im äußeren Randbereich der Innenfläche 100 sind Einfräsungen 103 vorgesehen, die den Wärmefluss zwischen dem zentralen, heißen Bereich der Innenfläche 100, in dem die Halbleiterwafer aufliegen, und dem kälteren Außenrand 101 einschränken und gleichzeitig schmale lange Stege stehen lassen, die den Aufbau mechanischer Spannungen als Folge der Temperaturdifferenz zwischen dem Auflagebereich der Halbleiterwafer auf der Innenfläche 100 und dem Außenrand 101 verhindern. In dem abgebogenen Außenrand 101 sind zusätzlich radiale Schlitze 104 und in der Innenfläche 100 des Suszeptors 1 mehrere kreisringförmige Ausnehmungen 105 zur Aufnahme der Halbleiterwafer vorgesehen.

Die thermische Trennung des Außenrandes 101 des Suszeptors 1 von der Innenfläche 100 für die Halbleiterwafer ermöglicht ein für den Thermomigrationsprozess vorteilhaftes schnelles Rampenfahren sowie eine größere Homogenität bei der Wärmeverteilung, da ansonsten ein erheblicher Anteil der im Suszeptor 1 generierten Wärme über den Außenrand 101 abgeführt werden würde.

Die Abwinklung des Außenrandes 101 dient der Vergrößerung des Abstandes von der stark erhitzten Innenfläche 100 zum Rand des Suszeptors 1, an dem die mechanischen Verbindungselemente 6 zur Verbindung des Suszeptors 1 mit der Wärmesenke bzw. dem Kühltopf 3 angreifen, so dass die Befestigungselemente 6 gemäß den Fig. 4 und 6 zur Verbindung des Suszeptors 1 mit der Wärmesenke 3 geringer wärmebelastet sind und in einem Bereich des Suszeptors 1 angeordnet werden, der außerhalb des vom Induktor 4 abgegebenen magnetischen Feldes liegt, so dass der Abstand zwischen dem Suszeptor 1 und dem Induktor 4 minimiert werden kann.

Alternativ kann anstelle eines napf- oder tellerförmigen Suszeptors auch ein scheibenförmiger Suszeptor verwendet werden, der über den äußeren kreisscheibenförmigen Rand mit der Wärmesenke verbunden wird. Dies bedingt zwar einen größeren Abstand zum Induktor, ermöglicht aber die Herstellung eines sehr einfach geformten Suszeptors. Diese Ausgestaltung des Suszeptors eignet sich insbesondere für die vereinfachte Ausführungsform der erfindungsgemäßen Thermomigrationsvorrichtung, bei der auf eine Trennung der Gasräume verzichtet wird und dadurch die Quarzglocke entfällt, so dass der Suszeptor als einfache zylindrische Scheibe gestaltet werden kann, da wegen des Wegfalls der Quarzglocke ein geringer Abstand zum Induktor ohne Probleme bei der Verbindung des Suszeptors mit der Wärmesenke eingestellt werden kann.

Die erfindungsgemäße Thermomigrationsvorrichtung ermöglicht es, den Abstand zwischen der Unterseite der Wärmesenke und der Oberseite des Halbleiterwafers auf ein Maß zu senken, das nur noch von der Qualität der Oberflächen abhängt und im Bereich weniger Zehntel Millimeter liegt. Damit können auch bei Suszeptoren mit großem Durchmesser von über 400 mm sehr kleine Abstände reproduzierbar und ohne Keiligkeit zwischen der Wärmsenke und der Suszeptoroberfläche eingestellt werden, die auch während der Rotation des Suszeptors unverändert bleiben, was eine grundlegende Voraussetzung für die gleichzeitige Bearbeitung mehrerer Halbleiterwafer bei minimaler Prozesszeit ist.

Die Trennung der Gasräume in einen die Halbleiterwafer aufnehmenden Prozessraum und einen den Induktor enthaltenden Induktorraum ermöglicht einen optimalen Betrieb in den mit unterschiedlichen Aufgaben und Funktionen zugewiesenen Kammern. Während in dem Prozessraum eine Gasatmosphäre hoher Wärmeleitfähigkeit und die Halbleiterreinheit und damit die Sauberkeit höchste Priorität besitzen, kommt es im Induktorraum im Wesentlichen darauf an, Spannungsüberschläge zu verhindern. Aus diesem Grunde können im Prozessraum Helium als Prozessgas mit hoher Wärmeleitung und ausschließlich die Halbleiterreinheit in Hochtemperaturprozessen gewährende hochreinen Materialien, wie für die heißen Teile Quarzglas und Graphit, und für die kalten Teile Aluminium und Edelstahl verwendet werden. Dagegen kann im Induktorraum ein inertes Gas wie Stickstoff oder SF6 eingesetzt werden, das eine höhere Spannungsüberschlagsfestigkeit aufweist.

Bei maximalen Ausgangsspannungen des MF-Generators von ca. 1 kV reichen bei diesen Gasen und ihren Gemischen im Induktorraum Drücke von 150 mb aus um Spannungsüberschläge zu vermeiden, so dass einer der Quarzglocke verträglichen Druckdifferenz von ca. 100 mb im Prozessraum mit 50 mb He-Druck gearbeitet werden kann. Dadurch kann bei geringen Massendurchsatz an Heliumgas im Prozessraum mit einer der Halbleiterreinheit im Prozeß förderlichen hohen laminaren Strömungsgeaschwindigkeit gearbeitet werden.

### Bezugszeichenliste

- 1: Suszeptor
- 2: Halbleiterwafer
- 3: Wärmesenke bzw. Kühltopf
- 4: Induktor
- 5: Rezipient
- 6: federgestraffte Verbindungselemente
- 7, 7a: zylindrische Abstandshalter
- 8: glockenförmiges Oberteil des Rezipienten
- 9: Drehdurchführung des Rezipienten
- 10: Welle (Rotationsachse)
- 11: Kühlflüssigkeitskanal
- 11 a: Kühlflüssigkeitskanal
- 12: Gaskanal
- 13: elektrisch isolierende Scheibe
- 14: Kühltopfboden
- 15: Zwischenwände
- 16: Quarzglocke
- 17: Flanschring
- 18: Elastomerringe
- 19: Rezipientenboden
- 20: zylinderförmiges Unterteil des Rezipienten
- 21: Ringspalt
- 23: stationäres Pyrometer
- 24: verfahrbares Pyrometer
- 25: Antriebsmotor
- 26: Transmissionselement
- 27: Quarzträgerring
- 28: Abstandshalter
- 29: Induktorleitungen
- 30: Aufnahmeelemente
- 31: Zylindermantel des Kühltopfes
- 32: Distanzstücke
- 38: Gaseinlaß Induktorkammer
- 39: Pumpstutzen
- 40,41: Pumpstutzen
- 42: Abpumpleitung
- 42a: Abpumpleitung der Induktorkammer
- 43: Vakuumpumpe
- 71: Differenzdrucksensor
- 72: Gasregelventil
- 73: Differenzdruckregler
- 74: Stickstoffeinlass
- 75: Gasdrucksensor
- 76: Druckregler
- 77: Drosselventil
- 100: kreisringförmige Innenfläche des Suszeptors
- 101: Außenrand des Suszeptors
- 102: zentrale Bohrung
- 103: Einfräsungen
- 104: radiale Schlitze
- 105: kreisringförmige Ausnehmungen
- 111, 112: Kanäle
- 191, 192: Messfenster
- P: Prozessraum
- S: Induktorraum

## Patentansprüche

1. Vorrichtung zur Herstellung elektrisch leitfähiger Durchgänge in einem Halbleiterwafer (2) mittels Thermomigration durch Erzeugen eines Temperaturgradienten zwischen den Oberflächen des Halbleiterwafers (2), der in einem vakuumdicht verschlossenen, ein gut wärmeleitendes Gas enthaltenden Rezipienten (5) zwischen einem als Wärmequelle dienenden, induktiv geheizten Suszeptor (1) und einer mit einem Kühlmedium durchströmten Wärmesenke (3) angeordnet ist und auf dessen der Wärmesenke (3) zugewandten Oberfläche (2) ein leitfähiger Dotierstoff aufgebracht ist,
**dadurch gekennzeichnet,**
**dass** der Suszeptor (1) mit der Wärmesenke (3) verbunden ist, die zusammen mit dem Suszeptor (1) drehbar über einem den Suszeptor (1) induktiv erwärmenden Induktor (4) angeordnet ist.

2. Vorrichtung nach Anspruch 1, **dadurch gekennzeichnet, dass** der Suszeptor (1) in Richtung der Wärmesenke (3) vorgespannt ist und dass zwischen der Wärmesenke (3) und dem Suszeptor (1) oder einer den Suszeptor (1) aufnehmenden Unterlage Abstandshalter (7, 7a, 28) und/oder Distanzstücke (32) angeordnet sind.

3. Vorrichtung nach Anspruch 1 oder 2, **dadurch gekennzeichnet, dass** die Wärmesenke aus einem rotationssymmetrischen Kühltopf (3) mit einem der Halbleiterwaferoberfläche zugewandten kreisscheiben- oder kreisringförmigen Kühltopfboden (14) besteht, vakuumdicht und drehbar durch eine Öffnung (9) des Rezipienten (5) geführt ist, und in seinem aus dem Rezipienten (5) herausragenden Teil mindestens einen zylindrischen Abschnitt (31), durch den das Kühlmedium zu- und abgeleitet wird, und eine vom Kühlmedium getrennte Leitung (12) zur Zufuhr des gut wärmeleitenden Gases aufweist.

4. Vorrichtung nach mindestens einem der voranstehenden Ansprüche, **dadurch gekennzeichnet, dass** der Rezipient (5) in zwei gasdicht voneinander getrennte Gasräume (P, S) unterteilt ist, von denen der eine Gasraum aus einem den Suszeptor (1) aufnehmenden Prozessraum (P) und der andere Gasraum aus einem den Induktor (4) aufnehmenden Induktorraum (S) besteht.

5. Vorrichtung nach Anspruch 4, **dadurch gekennzeichnet, dass** der Prozessraum (P) mit dem gut wärmeleitenden Gas, das die Waferoberfläche laminar umströmt, und der Induktorraum (S) mit einem Gas hoher Spannungs- oder Durchschlagsfestigkeit, insbesondere mit trockenem Stickstoff, SF₆ oder einer Mischung aus beiden Gasen, gefüllt ist oder durchströmt wird.

6. Vorrichtung nach Anspruch 5, **gekennzeichnet durch** unterschiedliche und in Abhängigkeit voneinander regelbare Gasdrücke im Prozessraum (P) und im Induktorraum (S).

7. Vorrichtung nach mindestens einem der voranstehenden Ansprüche 4 bis 6, **dadurch gekennzeichnet, dass** der Induktorraum (S) durch ein mit dem Boden (19) des Rezipienten (5) verbundenes elektrisch isolierendes Gefäß gasdicht vom Prozessraum (P) getrennt ist.

8. Vorrichtung nach mindestens einem der voranstehenden Ansprüche, **dadurch gekennzeichnet, dass** der Rezipient (5) aus einem den Suszeptor (1) und einen Teil des Kühltopfs (3) aufnehmenden Oberteil (8) und einem den Induktor (4) und/oder die den Induktor (4) enthaltende Quarzglocke (16) umgebenden Unterteil (20) besteht, das mit dem Boden (19) des Rezipienten (5) verbunden ist.

9. Vorrichtung nach Anspruch 8, **dadurch gekennzeichnet, dass** das mit dem Kühltopf (3) und dem Suszeptor (1) verbundene Oberteil (8) vom Unterteil (20) lösbar, anhebbar und wegschwenkbar ist.

10. Vorrichtung nach mindestens einem der voranstehenden Ansprüche, **dadurch gekennzeichnet, dass** die Temperatur des Außenrandes (101) des Suszeptors (1) niedriger ist als dessen den Halbleiterwafer (2) aufnehmende Innenfläche (100) und dass der Außenrand (101) des Suszeptors (1) lösbar mit einem im Randbereich des Kühltopfbodens (14) angeordneten Aufnahmeabschnitt (30) des Kühltopfs (3) verbunden ist.

11. Vorrichtung nach Anspruch 10, **dadurch gekennzeichnet, dass** zwischen dem Au-ßenrand (101) des Suszeptors (1) und der den Halbleiterwafer (2) aufnehmenden Innenfläche (100) des Suszeptors (1) ein den Wärmefluss von der Innenfläche (100) zum Außenrand (101) verringernder Abschnitt (103) vorgesehen ist.

12. Vorrichtung nach Anspruch 10 oder 11, **dadurch gekennzeichnet, dass** der Au-ßenrand (101) des Suszeptors (1) einen größeren vertikalen Abstand zum Induktor (4) als seine den Halbleiterwafer (2) aufnehmende Innenfläche (100) aufweist, und durch radiale Einschnitte unterbrochen ist.

13. Vorrichtung nach einem der Ansprüche 10 bis12, **dadurch gekennzeichnet, dass** der Außenrand (101) des Suszeptors (1) auf einer Unterlage aufliegt.

14. Vorrichtung nach Anspruch 13, **dadurch gekennzeichnet, dass** die Unterlage ringförmig ausgebildet ist und aus Quarzglas(27) ist.

15. Vorrichtung nach mindestens einem der voranstehenden Ansprüche, **dadurch gekennzeichnet, dass** der Abstand zwischen der Oberfläche des Halbleiterwafers (2) und dem Kühltopfboden (14) 0,1 bis 5 mm beträgt.

16. Vorrichtung nach Anspruch 15, **dadurch gekennzeichnet, dass** zwischen dem Kühltopfboden (14) und dem Außenrand (101) und/oder der Innenfläche (100) des Suszeptors (1) Abstandshalter (7) und/oder Distanzhülsen (32) angeordnet sind.

17. Vorrichtung nach Anspruch 16, **dadurch gekennzeichnet, dass** die Abstandshalter (7) und/oder Distanzhülsen (32) als Quarzglaszylinder ausgebildet sind.

18. Vorrichtung nach einem der Ansprüche 15 bis 17, **dadurch gekennzeichnet, dass** zwischen der Oberfläche der Unterlage (27) des Suszeptors (1) und dem Kühltopfboden (14) in Freimachungen im Außenrand (101) des Suszeptors (100) positionierte Abstandshalter (7a) vorgesehen sind.

19. Vorrichtung nach mindestens einem der voranstehenden Ansprüche, **dadurch gekennzeichnet, dass** zwischen der den Halbleiterwafer (2) aufnehmenden Innenfläche (100) des Suszeptors (1) und dem Halbleiterwafer (2) ein Trennmedium angeordnet ist.

20. Vorrichtung nach Anspruch 19, **dadurch gekennzeichnet, dass** das Trennmedium aus einer die Innenfläche (100) des Suszeptors (1) bedeckenden, passivierenden Schicht besteht.

21. Vorrichtung nach Anspruch 20, **dadurch gekennzeichnet, dass** die Schicht aus SiC, Al₂O₃ oder TiN bzw. einer Kombination dieser Verbindungen besteht.

22. Vorrichtung nach Anspruch 19, **dadurch gekennzeichnet, dass** das Trennmedium aus mehreren, dünnen Abstandshaltern, insbesondere ca. 7 bis 10 mm langen, 10 µm bis 50 µm dicken Quarzfasern, besteht.

23. Vorrichtung nach mindestens einem der voranstehenden Ansprüche, **dadurch gekennzeichnet, dass** im Innenraum des Kühltopfes (3) Blenden, Zwischenwände und/oder Versteifungsrippen vorgesehen sind und dass das Kühlmedium in den aus dem Rezipienten (5) ragenden Teil des Kühltopfes (3) eingeleitet, um die Rotationsachse (10) des Kühltopfes (3) zur Mitte der vom Suszeptor (1) abgewandten Oberfläche des Kühltopfbodens (14), entlang dieser Oberfläche zu deren äußerem Rand und zurück zu dem aus dem Rezipienten (5) ragenden Teil des Kühltopfes (3) geführt und dort abgeleitet wird.

24. Vorrichtung nach Anspruch 23, **dadurch gekennzeichnet, dass** an dem der vom Suszeptor (1) abgewandten Oberfläche des Kühltopfbodens (14) mehrere Kanäle angeordnet oder ausgebildet sind, deren Zahl sich mit zunehmendem Radius erhöht, während sich der Querschnitt jedes einzelnen Kanals dabei vermindert.

25. Vorrichtung nach mindestens einem der voranstehenden Ansprüche, **dadurch gekennzeichnet, dass** die Dicke des Kühltopfbodens (14) von innen nach außen abnimmt.

26. Vorrichtung nach mindestens einem der voranstehenden Ansprüche, **dadurch gekennzeichnet, dass** die Innenfläche des Kühltopfes (3) mit einer gut wärmeleitenden Passivierungsschicht bedeckt ist.

27. Vorrichtung nach Anspruch 26, **dadurch gekennzeichnet, dass** die Passivierungsschicht aus TiN, SiC oder DLC (diamantartigem Kohlenstoff) eine Schichtdicke von 100 bis 500 nm aufweist.

28. Vorrichtung nach mindestens einem der voranstehenden Ansprüche, **dadurch gekennzeichnet, dass** der vertikale Abstand zwischen dem inneren Bereich des Kühltopfbodens (14), unter dem sich kein Halbleiterwafer (2) befindet und der Ebene der Halbleiterwaferoberfläche größer ist als der Abstand zwischen den Abschnitten des Kühltopfbodens (14), die dem Halbleiterwafer (2) gegenüberliegen, und der Halbleiterwaferoberfläche.

29. Vorrichtung nach Anspruch 28, **dadurch gekennzeichnet, dass** der Abstand im Zentimeterbereich liegt.

30. Vorrichtung nach mindestens einem der voranstehenden Ansprüche, **dadurch gekennzeichnet, dass** das gut wärmeleitende Gas in den Halbleiterwaferraum (P) durch einen Mass-Flow-Controller gesteuert so eingelassen wird, dass es die Halbleiterwaferoberfläche laminar umströmt und über einen Saugstutzen (41) einer Vakuumpumpe (43) dem Prozessraum (P) entnommen wird, deren Saugleistung durch ein Drosselventil (77) einstellbar ist (Downstream-Regelung).

31. Vorrichtung nach mindestens einem der voranstehenden Ansprüche, **dadurch gekennzeichnet, dass** der Induktor (4) aus einer Induktionsspule besteht und dass die Induktorleitungen (29) durch eine elektrisch isolierte Durchführung durch den Rezipientenboden (19) geführt sind.

32. Vorrichtung nach Anspruch 31, **dadurch gekennzeichnet, dass** Induktionsspule aus einem spiral- oder mäanderförmig geformten Flächeninduktor gebildet ist.

33. Vorrichtung nach mindestens einem der voranstehenden Ansprüche, **dadurch gekennzeichnet, dass** eine die Rotationsachse des Kühltopfes (3) bildende, senkrecht zur Halbleiterwaferoberfläche stehende Welle (10) in dem außerhalb des Rezipienten (1) befindlichen Teil des Kühltopfes (3) über ein Transmissionsglied oder Getriebe (26) mit einem Antriebsmotor (25) verbunden ist.

34. Vorrichtung nach mindestens einem der voranstehenden Ansprüche, **dadurch gekennzeichnet, dass** Verbindungselemente (6), die den Suszeptor (1) mit dem Kühltopf (3) verbinden, Federn (60) aufweisen, die eine den Suszeptor (1) in Richtung des Kühltopfbodens (14) ziehende Kraft erzeugen, und dass die Verbindungselemente (6) einerseits am Außenrand (101) und/oder der Unterlage (27) des Suszeptors (1) und am Aufnahmeabschnitt (30) des Kühltopfes (3) angreifen.

35. Vorrichtung nach Anspruch 34, **dadurch gekennzeichnet, dass** die durch die Federn (60) erzeugte Kraft durch einfach geformte Körper oder in der Länge verstellbare Baugruppen aufgenommen wird, die sich zwischen dem Kühltopf (3) und dem Suszeptor (1) oder der Unterlage (27) des Suszeptors (1) befinden, und mit ihrer Länge den Abstand zwischen der Oberfläche des auf dem Suszeptor (1) liegenden Halbleiterwafers (2) und den gegenüberliegenden Abschnitten des Kühltopfbodens (14) bestimmen.

36. Vorrichtung nach mindestens einem der voranstehenden Ansprüche, **dadurch gekennzeichnet, dass** der Aufnahmeabschnitt (30) des Kühltopfes (3) als umlaufender Ring auf einem Zylindermantel (31) des Kühltopfes (3) ausgebildet ist.

37. Vorrichtung nach mindestens einem der voranstehenden Ansprüche, **dadurch gekennzeichnet, dass** der Kühltopf (3) als ein komplexes Gefäß aus Aluminium oder Aluminiumverbindungen ausgebildet ist.

38. Vorrichtung nach mindestens einem der voranstehenden Ansprüche, **dadurch gekennzeichnet, dass** ein offener Innenbereich des als Kreisringscheibe ausgebildeten Suszeptors (1) unterhalb einer Einlassöffnung des im Kühltopf (3) ausgebildeten Kanals (12) für das Prozessgas mit einer elektrisch isolierenden Scheibe (13) abgedeckt ist.

39. Vorrichtung nach mindestens einem der voranstehenden Ansprüche, **dadurch gekennzeichnet, dass** der Druck im Prozessraum (P) über die durch das Drosselventil (77) veränderbare Saugleistung der Vakuumpumpe (43) zwischen 5 und 1000 mbar einstellbar ist.

40. Vorrichtung nach mindestens einem der voranstehenden Ansprüche, **dadurch gekennzeichnet, dass** die den Induktorraum (S) umschliessende Quarzglocke (16) einen Flanschring (17) aufweist, der zwischen zwei elastischen Ringen an der Unterkante des Unterteils (20) des Rezipienten (5) und dem Rezipientenboden (19) eingespannt ist, wobei die Fuge, die sich zwischen dem Unterteils (20) und dem Flanschring (17) der Quarzglocke (16) bildet und die durch die elastischen Ringe vom Prozessraum (P) und Induktorraum (S) getrennt ist, evakuiert wird.

41. Vorrichtung nach mindestens einem der voranstehenden Ansprüche, **dadurch gekennzeichnet, dass** der Wärmestrom zwischen Suszeptor (1) und Wärmesenke (3) durch das Produkt der Temperaturdifferenz von dem in den Kühltopf (3) einströmenden und ausströmenden Kühlmedium, multipliziert mit seinem Volumenstrom und seiner spezifischen Wärmekapazität gemessen wird.

## Claims

1. Device for producing electroconductive passages in a semiconductor wafer (2) by means of thermomigration by generating a temperature gradient between the surfaces of the semiconductor wafer (2) which is mounted in a vacuum-sealed recipient (5) containing a good heat conductive gas, between an inductively heated susceptor (1) serving as heat source, and a heat sink (3) through which a cooling medium is passed and wherein a conductive doping substance is applied to the surface (2) facing the heat sink (3),
**characterised in that**
the susceptor (1) is connected to the heat sink (3) which is mounted together with the susceptor (1) rotatable above an inductor (4) inductively heating the susceptor (1).

2. Device according to claim 1, **characterised in that** the susceptor (1) is pretensioned in the direction of the heat sink (3) and that between the heat sink (3) and the susceptor (1) or a backing support holding the susceptor (1) there are spacers (7, 7a, 28) and/or distance members (32).

3. Device according to claim 1 or 2, **characterised in that** the heat sink consists of a rotationally symmetrical cooling pot (3) with a circular disc shaped or circular ring shaped cooling pot base (14) facing the semiconductor wafer surface, is guided vacuum-sealed and rotatable through an opening (9) in the recipient (5), and in its part projecting out from the recipient (5) has at least a cylindrical section (31) through which the cooling medium is supplied and discharged, and a pipe (12), separated from the coolant, for supplying the good heat-conductive gas.

4. Device according to at least one of the preceding claims, **characterised in that** the recipient (5) is divided into two gastight separated gas chambers (P, S) of which one gas chamber consists of a processing chamber (P) holding the susceptor (1) and the other gas chamber consists of an inductor chamber (S) holding the inductor (4).

5. Device according to claim 4, **characterised in that** the processing chamber (P) is filled with or has a flow of good heat-conductive gas, which flows in a laminar stream around the surface of the wafer, and the inductor chamber (S) is filled with a gas of high voltage insulation strength or disruptive strength SF₆ or a mixture of the two gases.

6. Device according to claim 5, **characterised by** different gas pressures controllable in dependence on each other in the processing chamber (P) and in the inductor chamber (S).

7. Device according to at least one of the preceding claims 4 to 6, **characterised in that** the inductor chamber (S) is separated gas-tight from the processing chamber (P) through an electrically insulating vessel connected to the base (19) of the recipient (5).

8. Device according to at least one of the preceding claims, **characterised in that** the recipient (5) consists of an upper part (8) holding the susceptor (1) and a part of the cooling pot (3), and of a lower part (20) surrounding the inductor (4) and/or the quartz bell (16) containing the inductor (4), wherein the lower part is connected to the base (19) of the recipient (5).

9. Device according to claim 8 **characterised in that** the upper part (8) connected to the cooling pot (3) and susceptor (1) can be detached, lifted off and pivoted away from the lower part (20).

10. Device according to at least one of the preceding claims, **characterised in that** the temperature of the outside edge (101) of the susceptor (1) is lower than its inside face (100) holding the semiconductor wafer (2) and that the outside edge (101) of the susceptor (1) is detachably connected to a socket section (30) of the cooling pot (3) mounted in the marginal region of the cooling pot base (14).

11. Device according to claim 10, **characterised in that** between the outer edge (101) of the susceptor (1) and the inside face (100) of the susceptor (1) holding the semiconductor wafer (2) there is a section (103) which reduces the heat flow from the inside face (100) to the outside edge (101).

12. Device according to claim 10 or 11, **characterised in that** the outside edge (101) of the susceptor (1) has a larger vertical distance from the inductor (4) than its inside face (100) holding the semiconductor wafer (2) and is interrupted by radial incisions.

13. Device according to one of claims 10 to 12, **characterised in that** the outside edge (101) of the susceptor (1) rests on a backing support.

14. Device according to Claim 13, **characterised in that** the backing support is a ring shaped backing support of quartz glass (27)

15. Device according to at least one of the preceding claims, **characterised in that** the distance between the surface of the semiconductor wafer (2) and the cooling pot base (14) amounts to 0.1 to 5 mm.

16. Device according to claim 15, **characterised in that** between the cooling pot base (14) and the outside edge (101) and/or the inside face (100) of the susceptor (1) there are spacers (7) and/or distance sleeves (32).

17. Device according to claim 16, **characterised in that** the spacers (7) and/or distance sleeves (32) are designed as quartz glass cylinders.

18. Device according to claim 15 to 17, **characterised in that** between the surface of the backing support (27) of the susceptor (1) and the cooling pot base (14) there are spacers (7a) positioned in clearances in the outside edge (101) of the susceptor (100).

19. Device according to at least one of the preceding claims, **characterised in that** a separating medium is provided between the inside face (100) of the susceptor (1) holding the semiconductor wafer (2) and the semiconductor wafer (2) itself.

20. Device according to claim 19, **characterised in that** the separating medium consists of a passivating layer covering the inside face (100) of the susceptor (1).

21. Device according to claim 20, **characterised in that** the layer consists of SiC, Al₂O₃ or TiN or a combination of these compounds.

22. Device according to claim 19, **characterised in that** the separating medium consists of several thin spacers, more particularly about 7 to 10 mm long, 10µm to 50µm thick quartz fibres.

23. Device according to at least one of the preceding claims, **characterised in that** in the inside of the cooling pot (3) there are shades, partitions and/or reinforcement ribs and that the cooling medium is introduced into the part of the cooling pot (3) projecting out from the recipient (5), is guided around the rotational axis (10) of the cooling top (3) towards the centre of the surface of the cooling pot base (14) remote from the susceptor (1), along this surface to the outer edge thereof and back to the part of the cooling pot (3) projecting out from the recipient where it is discharged.

24. Device according to claim 23, **characterised in that** on the surface of the cooling pot base (14) remote from the susceptor (1) there are several ducts whose number increases as the radius increases whilst the cross-section of each individual duct thereby reduces.

25. Device according to at least one of the preceding claims, **characterised in that** the thickness of the cooling pot base (14) decreases from inside outwards.

26. Device according to at least one of the preceding claims, **characterised in that** the inside face of the cooling pot (3) is covered with a good heat conductive passivating layer.

27. Device according to claim 26, **characterised in that** the passivating layer of TiN, SiC or DLC (diamond-type carbon) has a layer thickness of 100 to 500 nm.

28. Device according to at least one of the preceding claims, **characterised in that** the vertical spacing between the inside region of the cooling pot base (14) underneath which there is no semiconductor wafer (2) and the plane of the semiconductor wafer surface is greater than the distance between the sections of the cooling pot base (14) which are opposite the semiconductor wafer (2), and the semiconductor wafer surface.

29. Device according to claim 24, **characterised in that** the distance lies in the centimetre range.

30. Device according to at least one of the preceding claims, **characterised in that** the good heat conductive gas is let into the semiconductor wafer chamber (P) controlled through a mass-flow controller so that it flows in a laminar flow around the surface of the semiconductor wafer surface and is removed from the processing chamber (P) through a suction pipe (41) of a vacuum pump (43) whose suction power is adjustable through a throttle valve (77) - (Downstream regulation).

31. Device according to at least one of the preceding claims, **characterised in that** the inductor (4) consist of an induction coil and that the inductor leads (29) are guided through an electrically insulated passage through the recipient base (19).

32. Device according to claim 31, **characterised in that** the induction coil is formed as a helically or meander shaped surface inductor.

33. Device according to at least one of the preceding claims, **characterised in that** a shaft (10) forming the rotational axis of the cooling pot (3) and standing at right angles to the semiconductor wafer surface is connected in the part of the cooling pot (3) located outside of the recipient to a drive motor (25) through a transmission member or gearing (26).

34. Device according to at least one of the preceding claims, **characterised in that** connecting elements (6) which connect the susceptor (1) to the cooling pot (3) have springs (60) which generate a force drawing the susceptor (1) towards the cooling pot base (14), and that the connecting elements (6) engage on one side on the outer edge (101) and/or backing support (27) of the susceptor (1) and on the socket section (30) of the cooling pot (3).

35. Device according to claim 34, **characterised in that** the force generated by the springs (60) is taken up through simple shaped bodies or length adjustable structural groups which are located between the cooling pot (3) and the susceptor (1) or backing support (27) of the susceptor (1) and with their length determine the distance between the surface of the semiconductor wafer (2) lying on the susceptor (1) and the opposite sections of the cooling pot base (14).

36. Device according to at least one of the preceding claims, **characterised in that** the socket section (30) of the cooling pot (3) is designed as a circumferential ring on a cylinder jacket (31) of the cooling pot (3).

37. Device according to at least one of the preceding claims, **characterised in that** the cooling pot (3) is designed as a complex vessel of aluminium or aluminium compounds.

38. Device according to at least one of the preceding claims, **characterised in that** an open inner region of the susceptor (1) designed as a circular ring disc underneath an inlet opening of the duct (12) formed in the cooling pot (3) for the process gas is covered by an electrically insulating disc (13).

39. Device according to at least one of the preceding claims, **characterised in that** the pressure in the processing chamber (P) is adjustable between 5 and 1000 mbar through the suction power of the vacuum pump (43) which can be varied through the throttle valve (77).

40. Device according to at least one of the preceding claims, **characterised in that** the quartz bell (16) surrounding the inductor chamber (S) has a flange ring (17) which is clamped between two elastic rings on the underneath edge of the lower part (20) of the recipient (5)and the recipient base (19) whereby the gap which is formed between the lower part (20) and the flange ring (17) of the quartz bell (16) and which is separated from the processing chamber (P) and inductor chamber (S) by the elastic rings is evacuated.

41. Device according to at least one of the preceding claims, **characterised in that** the heat flow between the susceptor (1) and heat sink (3) is measured by the product of the temperature difference of the cooling medium flowing in and out of the cooling pot (3), multiplied with its volume flow and its specific heat capacity.

## Revendications

1. Dispositif de fabrication de passages électriquement conducteurs dans une tranche de semi-conducteur (2) au moyen d'une migration thermique en produisant un gradient de température entre les surfaces de la tranche de semi-conducteur (2) qui est disposée dans un récipient (5) scellé de façon étanche au vide contenant un gaz bon conducteur de chaleur entre un suscepteur (1) chauffé par induction servant de source de chaleur et un dissipateur thermique (3) parcouru par un fluide de refroidissement, et dont la surface (2) tournée vers le dissipateur thermique (3) se voit appliquer une impureté de dopage conductrice, **caractérisé en ce que** le suscepteur (1) est relié au dissipateur thermique (3) qui est disposé ensemble avec le suscepteur (1) de façon rotative via un inducteur (4) qui chauffe le suscepteur (1) par induction.

2. Dispositif selon la revendication 1, **caractérisé en ce que** le suscepteur (1) est polarisé dans la direction du dissipateur thermique (3) et **en ce qu'**entre le dissipateur thermique (3) et le suscepteur (1) ou un support qui reçoit le suscepteur (1) sont disposés des écarteurs (7, 7a, 28) et/ou des pièces intercalaires (32).

3. Dispositif selon la revendication 1 ou 2, **caractérisé en ce que** le dissipateur thermique se compose d'un pot de refroidissement (3) symétrique par rotation avec un fond de pot de refroidissement (14) en forme de disque ou de couronne dirigé vers la surface de la tranche de semi-conducteur, **en ce qu'**il est introduit de façon étanche au vide et rotative au travers d'une ouverture (9) du récipient (5), et **en ce qu'**il présente dans sa partie qui dépasse du récipient (5) au moins une partie cylindrique (31) au travers de laquelle le fluide de refroidissement est introduit puis extrait, et une conduite (12) séparée du fluide de refroidissement pour l'acheminement du gaz bon conducteur de chaleur.

4. Dispositif selon au moins une des revendications précédentes, **caractérisé en ce que** le récipient (5) est divisé en deux espaces réservés pour le gaz (P, S) séparés l'un de l'autre de façon étanche au gaz, dont l'un se compose d'une chambre de procédé (P) qui reçoit le suscepteur (1) et l'autre se compose d'une chambre d'induction (S) qui reçoit l'inducteur (4).

5. Dispositif selon la revendication 4, **caractérisé en ce que** la chambre de procédé (P) est remplie ou parcourue par le gaz bon conducteur de chaleur qui s'écoule en flux laminaire autour de la surface de tranche de semi-conducteur, et **en ce que** la chambre d'induction (S) est remplie ou parcourue par un gaz à haute résistance diélectrique ou à haute résistance au claquage, en particulier par de l'azote sec, SF₆ ou un mélange de ces deux gaz.

6. Dispositif selon la revendication 5, **caractérisé par** des pressions de gaz distinctes et réglables l'une par rapport à l'autre dans la chambre de procédé (P) et dans la chambre d'induction (S).

7. Dispositif selon au moins une des revendications 4 à 6, **caractérisé en ce que** la chambre d'induction (S) est séparée de façon étanche au gaz de la chambre de procédé (P) par un récipient isolant électriquement lié au fond (19) du récipient (5).

8. Dispositif selon au moins une des revendications précédentes, **caractérisé en ce que** le récipient (5) se compose d'une partie supérieure (8) qui reçoit le suscepteur (1) et une partie du pot de refroidissement (3), et d'une partie inférieure (20) qui entoure l'inducteur (4) et/ou une cloche de quartz (16) contenant l'inducteur (4), et qui est reliée au fond (19) du récipient (5).

9. Dispositif selon la revendication 8, **caractérisé en ce que** la partie supérieure (8) reliée au pot de refroidissement (3) et au suscepteur (1) peut se détacher de la partie inférieure (20), peut se soulever et peut s'enlever par basculement.

10. Dispositif selon au moins une des revendications précédentes, **caractérisé en ce que** la température de l'extrémité externe (101) du suscepteur (1) est inférieure à celle de la surface interne (100) qui reçoit la tranche de semi-conducteur (2), et **en ce que** l'extrémité externe (101) du suscepteur (1) est reliée de façon détachable à une section d'admission (30) du pot de refroidissement (3) disposée en bordure du fond du pot de refroidissement (14).

11. Dispositif selon la revendication 10, **caractérisé en ce qu'**il est prévu une partie (103) qui réduit le flux de chaleur de la surface interne (100) vers l'extrémité externe (101) du suscepteur (1) entre l'extrémité externe (101) du suscepteur (1) et la surface interne (100) qui reçoit la tranche de semi-conducteur (2).

12. Dispositif selon la revendication 10 ou 11, **caractérisé en ce que** l'extrémité externe (101) du suscepteur (1) présente une distance verticale plus grande par rapport à l'inducteur (4) que sa surface interne (100) qui reçoit la tranche de semi-conducteur (2) et est interrompue par des incisions radiales.

13. Dispositif selon l'une quelconque des revendications 10 à 12, **caractérisé en ce que** l'extrémité externe (101) du suscepteur (1) repose sur un support.

14. Dispositif selon la revendication 13, **caractérisé en ce que** le support (27) est de forme annulaire et est en verre de quartz.

15. Dispositif selon au moins une des revendications précédentes, **caractérisé en ce que** la distance entre la surface supérieure de la tranche de semi-conducteur (2) et le fond du récipient de refroidissement (14) est de 0,1 à 5 mm.

16. Dispositif selon la revendication 15, **caractérisé en ce que** des écarteurs (7) et/ou des pièces intercalaires (32) sont disposés entre le fond du pot de refroidissement (14) et l'extrémité externe (101) et/ou la surface interne (100) du suscepteur (1).

17. Dispositif selon la revendication 16, **caractérisé en ce que** les écarteurs (7) et/ou les pièces intercalaires (32) sont constitués de cylindres de verre de quartz.

18. Dispositif selon l'une quelconque des revendications 15 à 17, **caractérisé en ce que** sont prévus des écarteurs (7a) positionnés dans des espaces libres dans l'extrémité externe (101) du suscepteur (100) entre la surface supérieure du support (27) du suscepteur (1) et le fond du pot de refroidissement (14).

19. Dispositif selon au moins une des revendications précédentes, **caractérisé en ce qu'**il est disposé un milieu de séparation entre la surface interne (100) du suscepteur (1) qui reçoit la tranche de semi-conducteur (2) et la tranche de semi-conducteur (2).

20. Dispositif selon la revendication 19, **caractérisé en ce que** le milieu de séparation se compose d'une couche de passivation qui recouvre la surface interne (100) du suscepteur (1).

21. Dispositif selon la revendication 20, **caractérisé en ce que** la couche se compose de SiC, Al₂O₃ ou TiN ou bien d'un mélange de ces composés.

22. Dispositif selon la revendication 19, **caractérisé en ce que** le milieu de séparation se compose de plusieurs écarteurs minces, en particulier de fibres de quartz longs d'environ 7 à 10 mm et épais de 10 à 50 µm.

23. Dispositif selon au moins une des revendications précédentes, **caractérisé en ce que** sont prévus dans l'espace interne du pot de refroidissement (3) des écrans, des parois intermédiaires et/ou des nervures de rigidification, et **en ce que** le fluide de refroidissement est introduit dans la partie du pot de refroidissement (3) qui dépasse du récipient (5), est acheminé autour de l'axe de rotation (10) du pot de refroidissement (3) jusqu'au milieu de la surface supérieure du fond du pot de refroidissement (14) à l'écart du suscepteur (1), le long de cette surface supérieure jusqu'à son extrémité externe puis est ramené en sens inverse jusqu'à la partie du pot de refroidissement (3) qui dépasse du récipient (5) d'où il est extrait.

24. Dispositif selon la revendication 23, **caractérisé en ce que** plusieurs canaux sont disposés ou construits sur la surface du fond du pot de refroidissement (14) qui s'écarte du suscepteur (1), dont le nombre augmente quand le rayon augmente, alors que le diamètre de chacun de ces canaux se réduit.

25. Dispositif selon au moins une des revendications précédentes, **caractérisé en ce que** l'épaisseur du fond du pot de refroidissement (14) diminue de l'intérieur vers l'extérieur.

26. Dispositif selon au moins une des revendications précédentes, **caractérisé en ce que** la surface interne du pot de refroidissement (3) est recouverte d'une couche de passivation bonne conductrice de chaleur.

27. Dispositif selon la revendication 26, **caractérisé en ce que** la couche de passivation en TiN, SiC ou DLC (carbone diamanté) présente une épaisseur de 100 à 500 nm.

28. Dispositif selon au moins une des revendications précédentes, **caractérisé en ce que** la distance verticale entre la zone interne de l'épaisseur du fond du pot de refroidissement (14), sous lequel il n'y a pas de tranche de semi-conducteur (2), et le niveau de la surface supérieure de la tranche de semi-conducteur est supérieure à la distance entre les parties du pot de refroidissement (14) qui font face à la tranche de semi-conducteur (2) et la surface supérieure de la tranche de semi-conducteur (2).

29. Dispositif selon la revendication 28, **caractérisé en ce que** la distance est du domaine du centimètre.

30. Dispositif selon au moins une des revendications précédentes, **caractérisé en ce que** le gaz bon conducteur de chaleur contrôlé par un contrôleur de débit massique est introduit dans la chambre de la tranche de semi-conducteur (P) de telle manière qu'il s'écoule en flux laminaire autour de la surface de tranche de semi-conducteur et est extrait de la chambre de procédé (P) via une buse d'aspiration (41) d'une pompe à vide (43) dont on peut régler le rendement d'aspiration grâce à une vanne papillon (77) (réglage en aval).

31. Dispositif selon au moins une des revendications précédentes, **caractérisé en ce que** l'inducteur (4) se compose d'une bobine d'induction, et **en ce que** les conduites de l'inducteur (29) sont acheminées via un passage isolé électriquement au travers du fond du récipient (19).

32. Dispositif selon la revendication 31, **caractérisé en ce que** la bobine d'induction est constituée d'un inducteur de surface en forme de spirale ou rectangulaire.

33. Dispositif selon au moins une des revendications précédentes, **caractérisé en ce qu'**un arbre (10) formant l'axe de rotation du pot de refroidissement (3) et disposé perpendiculairement à la surface supérieure de la tranche de semi-conducteur est relié à un moteur d'entraînement (25) via un arbre de transmission ou un engrenage (26) dans la partie du pot de refroidissement (3) située hors du récipient (5).

34. Dispositif selon au moins une des revendications précédentes, **caractérisé en ce que** des éléments de raccordement (6) qui relient le suscepteur (1) au pot de refroidissement (3) présentent des ressorts (60) qui produisent une force de rappel pour le suscepteur (1) dans la direction du fond du pot de refroidissement (14), et **en ce que** les éléments de raccordement (6) sont en prise d'une part avec l'extrémité externe (101) et/ou le support (27) du suscepteur (1) et d'autre part avec la partie réceptrice (30) du pot de refroidissement (3).

35. Dispositif selon la revendication 34, **caractérisé en ce que** la force de rappel produite par les ressorts (60) est reçue par des éléments formés de façon simple ou réglables en longueur qui se trouvent entre le pot de refroidissement (3) et le suscepteur (1) ou le support (27) du suscepteur (1), et qui déterminent par leur longueur la distance entre la surface supérieure de la tranche de semi-conducteur (2) située sur le suscepteur (1) et les parties du fond du pot de refroidissement (14) qui sont situées en face d'elle.

36. Dispositif selon au moins une des revendications précédentes, **caractérisé en ce que** la partie réceptrice (30) du pot de refroidissement (3) est constituée comme un anneau sur de la surface cylindrique (31) du pot de refroidissement (3).

37. Dispositif selon au moins une des revendications précédentes, **caractérisé en ce que** le pot de refroidissement (3) est constitué d'un récipient complexe en aluminium ou en alliages d'aluminium.

38. Dispositif selon au moins une des revendications précédentes, **caractérisé en ce qu'**une zone interne ouverte du suscepteur (1) en forme de disque, en dessous d'une ouverture d'admission du canal (12) formé dans le pot de refroidissement (3) pour le gaz de procédé, est recouverte d'un disque (13) isolant électrique.

39. Dispositif selon au moins une des revendications précédentes, **caractérisé en ce que** la pression dans la chambre de procédé (P) est réglable entre 5 et 1000 mbar via le rendement d'aspiration de la pompe à vide (43) modifiable au moyen de la vanne papillon (77).

40. Dispositif selon au moins une des revendications précédentes, **caractérisé en ce que** la cloche de quartz (16) qui entoure la chambre d'induction (S) présente une collerette annulaire (17) qui est montée entre deux anneaux élastiques sur l'arête inférieure de la partie inférieure (20) du récipient (5) et sur le fond du récipient (19), par lequel la fente qui se forme entre la partie inférieure (20) et la collerette annulaire (17) de la cloche de quartz (16) et qui est séparée par les anneaux élastiques de la chambre de procédé (P) et de la chambre d'induction (S) est éliminée.

41. Dispositif selon au moins une des revendications précédentes, **caractérisé en ce que** le flux de chaleur entre le suscepteur (1) et le dissipateur thermique (3) est mesuré par le produit de la différence de température du fluide de refroidissement entrant dans et sortant du pot de refroidissement (3) multiplié par son débit volumique et sa capacité calorifique spécifique.
